# EUROPEAN PATENT SPECIFICATION

(11) **EP 4 322 284 B1**
(45) Date of publication and mention of the grant of the patent: **25.03.2026**
(21) Application number: 22803920.2
(22) Date of filing: 16.05.2022
(51) Int. Cl.: H01M 10/617, H01M 10/6556

(54) **ENERGY STORAGE MODULE, ENERGY STORAGE APPARATUS, AND POWER GENERATION SYSTEM**
ENERGIESPEICHERMODUL, ENERGIESPEICHERVORRICHTUNG UND STROMERZEUGUNGSSYSTEM
MODULE DE STOCKAGE D'ÉNERGIE, APPAREIL DE STOCKAGE D'ÉNERGIE ET SYSTÈME DE GÉNÉRATION D'ÉNERGIE

(30) Priority: 17.05.2021 CN 202110535990
(43) Date of publication of application: 14.02.2024
(73) Proprietor: Huawei Digital Power Technologies Co., Ltd., Shenzhen, Guangdong 518043 (CN)
(72) Inventor: MA, Ruisheng, Shenzhen, Guangdong 518043 (CN); MENG, Hao, Shenzhen, Guangdong 518043 (CN)
(74) Representative: Maiwald GmbH
(86) International application number: PCT/CN2022/093071
(87) International publication number: WO 2022/242600

(56) References cited:
- EP-A1- 4 071 891
- CN-A- 111 867 338
- CN-A- 113 364 027
- CN-U- 211 350 905
- CN-U- 211 350 905
- CN-U- 211 350 906
- JP-A- 2014 112 479
- US-A1- 2010 047 672
- US-B2- 10 006 722
- US-B2- 10 374 269
- US-B2- 8 124 262
- US-B2- 8 507 122

## Description

### TECHNICAL FIELD

This application relates to the field of energy storage technologies, and in particular, to an energy storage module, an energy storage apparatus, and a power generation system.

### BACKGROUND

To overcome a severe intermittent problem of large-scale photovoltaic power generation and wind power generation, and with a rapid decrease in energy storage apparatus costs, a battery energy storage apparatus has been rapidly developed both on a power generation side and on a power consumption side due to features such as application flexibility, controllability, and energy density, and an installed capacity has also increased significantly.

An energy storage module includes a plurality of cells. In a process of heat dissipation for the energy storage module, temperatures of the cells at different locations are different. During long-term operation, an excessively large temperature difference between different cells causes an obvious difference between a state of health of a high-temperature cell and a state of health of a low-temperature cell. A capacity of an energy storage module is limited by a cell in a lowest state of health. An excessively large temperature difference between cells causes a decrease in a capacity of a cell with a high temperature. As a result, an overall capacity of the energy storage module is reduced, and overall benefits of the system are reduced.

US 10,374,269 B2 describes a battery pack.

Therefore, how to reduce a temperature difference between cells in an energy storage module to maximize capacity utilization of the energy storage module should be a research and development direction in the industry.

### SUMMARY

This application provides an energy storage module, an energy storage apparatus, and a power generation system, to reduce a temperature difference between cells in an energy storage module, to maximize a capacity and utilization of the energy storage module.

According to a first aspect, this application provides an energy storage module. The energy storage module includes a first cell, a second cell, and an air channel mechanical part. An air channel is disposed in the air channel mechanical part, the air channel mechanical part includes an air inlet end and an air outlet end that are located at two ends of the air channel, the first cell and the second cell are disposed outside the air channel mechanical part and are sequentially arranged between the air inlet end and the air outlet end, wherein the first cell is located between the second cell and the air inlet end, the air channel mechanical part includes a first air channel region and a second air channel region, wherein the air inlet end is located in the first air channel region and the air outlet end is located in the second air channel region, the first air channel region is disposed correspondingly with the first cell, the second air channel region is disposed correspondingly with the second cell, and a heat dissipation area per unit volume of the second air channel region is greater than a heat dissipation area per unit volume of the first air channel region, to reduce a temperature difference between the second cell and the first cell, wherein the air channel mechanical part comprises a heat dissipation part, the heat dissipation part is fastened to an inner wall of the second air channel region, and the heat dissipation part is configured to increase the heat dissipation area per unit volume of the second air channel region. The first air channel region and the second air channel region are connected to form the air channel, and the first air channel region and the second air channel region (that is, the air channel mechanical part) may be aluminum profiles or other channel mechanical parts. In this application, the first cell is located between the second cell and the air inlet end, which may also be understood as that the first cell is disposed near the air inlet end, the second cell is disposed near the air outlet end, and cold air for dissipating heat for the energy storage module successively passes through the air inlet end, a corresponding region (the first air channel region) of the first cell, a corresponding region (the second air channel region) of the second cell, and the air outlet end, to dissipate heat for the first cell and the second cell in sequence.

In this application, the heat dissipation area per unit volume of the second air channel region is set to be greater than the heat dissipation area per unit volume of the first air channel region, so that a problem of an excessively large temperature difference between the first cell and the second cell can be resolved. Specifically, in a working process of the energy storage module, the cell generates heat energy. A temperature control component is usually used to dissipate heat for the cell. The temperature control component may be an air conditioner or another cooling device. The cold air produced by the temperature control component enters from the air inlet end and passes by the first cell and the second cell in sequence (it should be noted that the cold air actually passes through the first air channel region and the second air channel region in sequence. Because the first air channel region that is disposed correspondingly with the first cell and the second air channel region that is disposed correspondingly with the second cell are configured to dissipate heat for the first cell and the second cell, it may be understood that the cold air passes by the first cell and the second cell) and takes away heat energy of the first cell and the second cell, then, the heat is converted into hot air and transmitted to the air outlet end for dissipation, to dissipate heat for the first cell and the second cell. However, when the cold air passes by the first cell, the cold air takes away heat energy of the first cell, so that a temperature of the first cell is lowered. In this case, a temperature of the cold air is higher than a temperature of the cold air existing before the cold air passes by the first cell, and the temperature of the cold air existing after passing by the first cell is raised. When the cold air continues to be transmitted to the second cell, heat energy of the second cell absorbed by the cold air is less (compared with the heat energy of the first cell that is absorbed), and therefore a temperature of the second cell is higher than the temperature of the first cell. As a result, a temperature difference between the first cell and the second cell is large, a state of health of the high-temperature second cell is significantly different from a state of health of the low-temperature first cell, a capacity of the energy storage module is limited by the second cell in a lowest state of health, and an excessively large temperature difference between the first cell and the second cell reduces the capacity of the energy storage module. As a result, overall benefits of a system are reduced. In other words, the temperature of the first cell that is closer to the air inlet end is lower, and the temperature of the second cell that is closer to the air outlet end is higher, that is, the temperature of the second cell is higher than the temperature of the first cell. The cold air produced by the temperature control component is transmitted by using the air channel mechanical part. In this application, the heat dissipation area per unit volume of the second air channel region corresponding to the second cell is set to be greater than the heat dissipation area per unit volume of the first air channel region corresponding to the first cell, so that effective heat dissipation of the second cell can be implemented, and the temperature difference between the second cell and the first cell is reduced, maximizing utilization of the capacity of the energy storage module and helping improve energy yields in a life cycle. If it is ensured that energy yields in the life cycle are the same, and a temperature difference between the first cell and the second cell in the energy storage module is reduced, operating energy consumption can be reduced, and initial investment can be reduced.

The air channel mechanical part includes a heat dissipation part, the heat dissipation part is fastened to an inner wall of the second air channel region, and the heat dissipation part is configured to increase the heat dissipation area per unit volume of the second air channel region. The heat dissipation part and the second air channel region may be of an integrated structure, and an assembly process is simplified. The heat dissipation part and the second air channel region may also be of a split structure. The heat dissipation part is disposed only in the second air channel region, so that heat energy of the second cell can be effectively dissipated, which helps reduce the temperature difference between the second cell and the first cell. For example, when the temperature difference between the first cell and the second cell is greater than 5°C, the heat dissipation part may be disposed in the second air channel region, to reduce the temperature difference between the first cell and the second cell. In another implementation, when the temperature difference between the first cell and the second cell is 4°C or 3°C, the heat dissipation part may be disposed in the second air channel region. This is not limited in this application.

In a possible implementation, an extension direction of the air channel is a first direction, a second direction is perpendicular to the first direction, and in the second direction, the second air channel region includes a middle portion and edges located on two sides of the middle portion, a length that is of the heat dissipation part and that is in the middle portion is greater than a length that is of the heat dissipation part and that is on the edge, and the length is an extension size of the heat dissipation part in the first direction. It should be noted that the middle portion is only a position between the two edges on the two sides in the second direction, and is not limited to a middle position between the two edges. A plurality of second cells may be arranged in the second direction, and a second cell near the edge has a lower temperature (compared with a second cell in the middle portion) due to natural heat dissipation of air around the energy storage module. Therefore, the length that is of the heat dissipation part in the middle portion of the second air channel region is set to be greater than the length that is of the heat dissipation part on the edge of the second air channel region. In this way, a temperature difference of the plurality of second cells arranged in the second direction may be reduced, and a material of the heat dissipation part may be less, to reduce costs.

In a possible implementation, an extension direction of the air channel is a first direction, the second air channel region includes a first sub-region, a second sub-region, and a third sub-region that are sequentially distributed in the first direction, an end that is of the third sub-region and that is away from the second sub-region is the air outlet end, and a heat dissipation area per unit volume of the third sub-region is greater than a heat dissipation area per unit volume of the second sub-region, and the heat dissipation area per unit volume of the second sub-region is greater than a heat dissipation area per unit volume of the first sub-region. In the first direction, there may be a plurality of second cells, and a temperature of a second cell that is closer to the air outlet end is higher. The first sub-region, the second sub-region, and the third sub-region are disposed correspondingly with the plurality of second cells. In this implementation, the heat dissipation areas per unit volume of the first sub-region to the third sub-region are gradually increased, which helps reduce the temperature difference between the plurality of second cells and the temperature difference between the second cell and the first cell.

In a possible implementation, a quantity of arranged first cells is greater than a quantity of arranged second cells in the extension direction of the air channel. For example, in the first direction, there may be three first cells, and there may be one second cell. In an actual setting process, when the temperature difference between the second cell and the first cell is greater than a threshold, a structure that can increase a heat dissipation area is disposed in the second air channel region corresponding to the second cell, which helps reduce the temperature difference between the second cell and the first cell. In this embodiment, the quantity of first cells is greater than the quantity of second cells, so that a volume of the second air channel region can be reduced, to reduce manufacturing costs.

In a possible implementation, the heat dissipation part includes a first plate, a second plate, a third plate, and a fourth plate that are sequentially connected, the second plate and the fourth plate are spaced apart in a second direction, the first plate and the third plate are disposed in a staggered manner in the second direction, and the second direction is perpendicular to an extension direction of the air channel. In this implementation, the first plate, the second plate, the third plate, and the fourth plate may form a heat dissipation unit. The heat dissipation part may include a plurality of heat dissipation units. The plurality of heat dissipation units are sequentially connected and fastened to the inner wall of the second air channel region to increase the heat dissipation area of the second air channel region, implement effective heat dissipation for the second cell, reduce the temperature difference between the second cell and the first cell, and maximize utilization of the capacity of the energy storage module.

In a possible implementation, the heat dissipation part includes a heat sink fin, and the heat sink fin is fastened to the inner wall of the second air channel region. There may be a plurality of heat sink fins, and the plurality of heat sink fins are spaced apart with each other. In this implementation, the heat dissipation area per unit volume of the second air channel region is increased by disposing the heat sink fins, which facilitates heat dissipation of the second cell, reduces the temperature difference between the second cell and the first cell, and maximizes utilization of the capacity of the energy storage module.

In a possible implementation, the heat dissipation part includes a bent plate, and the bent plate is fastened to the inner wall of the second air channel. The bent plate can effectively increase the heat dissipation area per unit volume of the second air channel region, facilitating heat dissipation of the second cell, reducing the temperature difference between the second cell and the first cell, and maximizing utilization of the capacity of the energy storage module.

In a possible implementation, the energy storage module includes a heat-conducting part, and the heat-conducting part is located between the second air channel region and the second cell. The heat-conducting part is used to fast transfer the heat energy produced by the second cell to the cold air that passes through the second air channel region, to reduce the temperature of the second cell and reduce the temperature difference between the second cell and the first cell. It can be understood that a heat conductivity coefficient of the heat-conducting part is greater than a heat conductivity coefficient of the air channel mechanical part. A main function of the heat-conducting part is to conduct heat energy between the second cell and the second air channel region. The heat conductivity coefficient of the heat-conducting part is usually high. For example, the air channel mechanical part may be made of aluminum, and the heat-conducting part may be made of copper with a high heat conductivity coefficient to achieve fast heat conduction. To improve a heat conduction capability of the heat-conducting part, a phase change medium may be set in the heat-conducting part. The phase change medium may be water or the like. Specifically, the heat-conducting part may be a heat pipe, a temperature equalizing plate, or the like. The heat-conducting part includes a capillary structure, the capillary structure is located on an inner wall of the heat-conducting part, the phase change medium is located in a cavity of the heat-conducting part, and heat is absorbed in a region in the heat-conducting part in which the heat-conducting part is in contact with the second cell, so that the phase change medium in the heat-conducting part is heated and vaporized, that is, water changes from a liquid state to gas, and the gas flows in the cavity to another region in the heat-conducting part. In a region in the heat-conducting part in which the heat-conducting part is in contact with the second air channel region, because of a low temperature, the gas liquefies into a liquid, and heat energy is released at the same time. The heat energy is conducted to the second air channel region, and the liquid is adsorbed on the capillary structure and transmitted to the second cell side through the capillary structure. In this way, a gas-liquid two-phase cycle is formed, and heat energy is fast conducted, improving heat-conducting efficiency of the heat-conducting part.

In a possible implementation, an elastic member is disposed between the heat-conducting part and the second cell, and the elastic member is configured to fill a gap between the heat-conducting part and the second cell. It may be understood that an elastic member may also be disposed between the heat-conducting part and the second air channel region, and the elastic member is configured to fill a gap between the heat-conducting part and the second air channel region. The elastic member may be graphite foam, a phase change film, a liquid metal, silicone thermal grease, or thermal gel. One side of the heat-conducting part is connected to the second cell, and the other side of the heat-conducting part is connected to the second air channel region. Elastic members may be disposed between the heat-conducting part and the second cell and between the heat-conducting part and the second air channel region. The elastic members are configured to fill a gap between the heat-conducting part and the second cell and between the heat-conducting part and the second air channel region, to improve heat dissipation efficiency. Specifically, the heat-conducting part and the second cell are used as an example. In one aspect, the heat-conducting part may not be in full contact with the second cell due to existence of a mechanical tolerance, in another aspect, when the heat-conducting part and the second cell are in contact with each other, even if surface flatness of the heat-conducting part and the second cell is good, close contact cannot be achieved, and only partial contact can be achieved. There are still many extremely small gaps or holes between the two materials, and a heat conductivity coefficient of air in the gaps is low, which increases heat resistance, a heat conduction path is blocked. Therefore, the elastic member is filled between the heat-conducting part and the second cell, the gap between the heat-conducting part and the second cell can be filled, air in the gap can be removed, heat resistance is reduced, and heat energy transfer efficiency is improved. In other words, the heat-conducting part and the second cell may be in a close contact connection with each other by pressing the elastic member, to avoid a problem that heat dissipation efficiency is reduced because the heat-conducting part cannot be in a close contact connection to the second cell due to a specific mechanical tolerance and surface roughness.

In a possible implementation, at least two first cells are disposed in a third direction, at least two second cells are spaced apart in the third direction, and in the third direction, the first air channel region is spaced apart between adjacent first cells, the second air channel region is spaced apart between adjacent second cells, and the third direction is perpendicular to an extension direction of the air channel. In other words, the first cells may be stacked in the third direction, the second cells may be stacked in the third direction, and in the third direction, the air channel mechanical part is disposed between adjacent cells. It can be understood that, when a plurality of first cells and second cells are stacked into a plurality of layers in the third direction, temperatures of a first cell and a second cell of an inner layer are higher than temperatures of a first cell and a second cell of an outer layer. In this implementation, the air channel mechanical part is disposed between two adjacent layers of cells to dissipate heat of the first cell and the second cell of the inner layer, the air channel mechanical part may also be set on an outer side of a cell of an outermost layer, which helps dissipate heat for the first cell and the second cell of the outer layer and reduce temperature differences between the first cell and second cell of the inner layer, and the first cell and the second cell of the outer layer. It should be noted that the first cell and the second cell of the inner layer and the first cell and the second cell of the outer layer refer to that, in the third direction, two layers of cells respectively located at an uppermost layer and a lowermost layer are the first cells and the second cells of the outer layers, and the first cell and the second cell of the inner layer are located between the first cells and second cells of the two outer layers.

In a possible implementation, the air inlet end is provided with an air inlet panel, the air inlet panel is provided with a first hole region, a second hole region, and a third hole region that are sequentially arranged in the third direction, the first hole region, the second hole region, and the third hole region are all provided with air inlet holes and in communication with the air channel mechanical part, and a quantity of air inlet holes in the second hole region is greater than a quantity of air inlet holes in the first hole region and greater than a quantity of air inlet holes in the third hole region, or a size of the air inlet hole in the second hole region is greater than a size of the air inlet hole in the first hole region and greater than a size of the air inlet hole in the third hole region. It should be noted that, in an example in which the air inlet hole is a circular hole, the size of the air inlet hole is a diameter of the air inlet hole, and specifically, an area of the air inlet hole. In an example in which the air inlet hole is a rectangular, square, or another shape, the size of the air inlet hole is an area of the air inlet hole. Cold air entering through the first hole region and the third hole region is used to dissipate heat for the first cell and the second cell of the outer layer, and cold air entering through the second hole region is used to dissipate heat for the first cell and the second cell of the inner layer. The first cell and the second cell of the outer layer are at a temperature lower than a temperature of the first cell and the second cell of the inner layer, in contact with environment outside the energy storage module. Therefore, the first cell and the second cell of the outer layer do not need excessive cold air. In this way, the quantity of air inlet holes in the second hole region corresponding to the first cell and the second cell of the inner layer may be set to be greater than the quantity of air inlet holes in the first hole region and greater than the quantity of air inlet holes in the third hole region, or the size of the air inlet hole in the second hole region is greater than the size of the air inlet hole in the first hole region and greater than the size of the air inlet hole in the third hole region, so that more cold air passes through the air inlet hole in the second hole region to dissipate heat for the first cell and the second cell of the inner layer, to reduce the temperature differences between the first cell and the second cell of the inner layer, and the first cell and the second cell of the outer layer. In a possible implementation, the energy storage module includes a side panel and a busbar, the side panel and the first cell are spaced apart in a second direction, the second direction is perpendicular to an extension direction of the air channel, the busbar is fastened to a side that is of the first cell and that faces the side panel, there is a gap between the busbar and the side panel, an edge of the air inlet panel is provided with a side hole region, the side hole region and the first hole region are disposed at an included angle, and an air inlet hole of the side hole region is in communication with the gap.

A current produced by each first cell and each second cell flows to the busbar and then to an electrode of the energy storage module. During current transmission, the busbar generates heat energy. The gap between the busbar and the side panel is set, so that cold air may dissipate heat for the busbar through the gap between the busbar and the side panel. The cold air may also be used to dissipate heat for the first cell and the second cell through the gap between the busbar and side panel, which can effectively reduce a temperature of an internal part of the energy storage module. Specifically, the cool air may dissipate heat for the busbar through entering the gap between the busbar and side panel from the air inlet hole of the side hole region. A heat dissipation effect is good, and heat dissipation efficiency is high.

In a possible implementation, the energy storage module includes a single plate box and a single plate located in the single plate box, the air outlet end is provided with an air control component, the air channel mechanical part is in communication with the air control component, the single plate box is provided with an air outlet side, the air outlet side is in communication with the air control component, and the air control component is configured to dissipate heat for the single plate. The single plate is a battery management module, and may be configured to collect data such as temperatures and voltages of the first cell and the second cell. The air control component may be a fan. The single plate box is provided with an air inlet side and an air outlet side. Cold air enters from the air inlet side to dissipate heat for the single plate and exits from the air outlet side. In this implementation, the single plate, the first cell, and the second cell share one air control component, which can reduce costs, reduce internal space of the energy storage module, and implement miniaturization of the energy storage module.

According to a second aspect, this application provides an energy storage apparatus. The energy storage apparatus includes a housing, a temperature control component, and the energy storage module according to any one of the foregoing implementations. The energy storage module and the temperature control component are both located in the housing, and the temperature control component is configured to dissipate heat for the energy storage module. The temperature control component may be an air conditioner or other equipment with cooling function. Cool air produced by the temperature control component is transmitted to the air channel mechanical part through the air inlet end, to dissipate heat for the first cell and the second cell. It can be understood that the energy storage apparatus may include a plurality of energy storage modules, and the energy storage modules may be distributed in array in the housing.

According to a third aspect, this application provides a power generation system. The power generation system includes a combiner box and the energy storage apparatus according to the second aspect, and the energy storage apparatus is connected to the combiner box.

According to a fourth aspect, this application provides a power generation system. The power generation system includes a transformer and the energy storage apparatus according to the second aspect, and the energy storage apparatus is connected to the transformer.

In this application, a heat dissipation area per unit volume of a second air channel region is set to be greater than a heat dissipation area per unit volume of a first air channel region, so that effective heat dissipation of the second cell is implemented, and a temperature difference between a second cell and a first cell is reduced, to maximize utilization of a capacity of an energy storage module, and help improve energy yields in a life cycle. In addition, in this application, a heat dissipation part that can increase a heat dissipation area is disposed in the second air channel region corresponding to the second cell, and space for the energy storage module is not increased additionally. In addition, in this application, a requirement for a temperature control component does not need to be increased (that is, the temperature control component does not need to be adjusted to generate more cold air, and the temperature control component does not need to be adjusted to generate cold air with a lower temperature), so that the temperature difference between the second cell and the first cell can be effectively reduced. This avoids increasing overall energy consumption of an energy storage apparatus, and reduces energy storage costs.

### BRIEF DESCRIPTION OF DRAWINGS

To describe technical solutions in embodiments of this application more clearly, the following describes the accompanying drawings used in embodiments of this application.
FIG. 1 is a schematic diagram of a structure of a power generation system according to an embodiment of this application;
FIG. 2 is a schematic diagram of a structure of another power generation system according to an embodiment of this application;
FIG. 3 is a schematic diagram of a structure of an energy storage apparatus according to an embodiment of this application;
FIG. 4 is a schematic diagram of a structure of an energy storage module according to an embodiment of this application;
FIG. 5 is a schematic diagram of a structure of another energy storage module according to an embodiment of this application;
FIG. 6 is an exploded view of an energy storage module according to an embodiment of this application;
FIG. 7 is a schematic diagram of a combined structure of an energy storage module according to an embodiment of this application;
FIG. 8 is a schematic diagram of a three-dimensional structure of a second air channel mechanical part according to an embodiment of this application;
FIG. 9 is a schematic diagram of a planar structure of a second air channel mechanical part according to an embodiment of this application;
FIG. 10 is a schematic diagram of a split structure of a second air channel mechanical part according to an embodiment of this application;
FIG. 11 is an enlarged schematic diagram of a structure shown at X1 in FIG. 8 according to this application;
FIG. 11A is a schematic diagram of a structure of a second air channel mechanical part according to an embodiment of this application;
FIG. 12 is a schematic diagram of a structure of an energy storage module according to an embodiment of this application;
FIG. 13 is a schematic diagram of a three-dimensional structure of a second air channel mechanical part according to an embodiment of this application;
FIG. 14 is an enlarged schematic diagram of a structure shown at X2 in FIG. 13 according to this application;
FIG. 14A is a schematic diagram of a structure of a second air channel mechanical part according to an embodiment of this application;
FIG. 15 is a schematic diagram of a structure of an energy storage module according to an embodiment of this application;
FIG. 16 is a schematic diagram of a structure of an air inlet panel according to an embodiment of this application;
FIG. 17 is a schematic diagram of a structure of a first air channel mechanical part according to an embodiment of this application;
FIG. 18 is a schematic diagram of a structure of an insulation cover plate according to an embodiment of this application; and
FIG. 19 is a schematic diagram of a structure of an energy storage module according to an embodiment of this application.

### DESCRIPTION OF EMBODIMENTS

The following describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

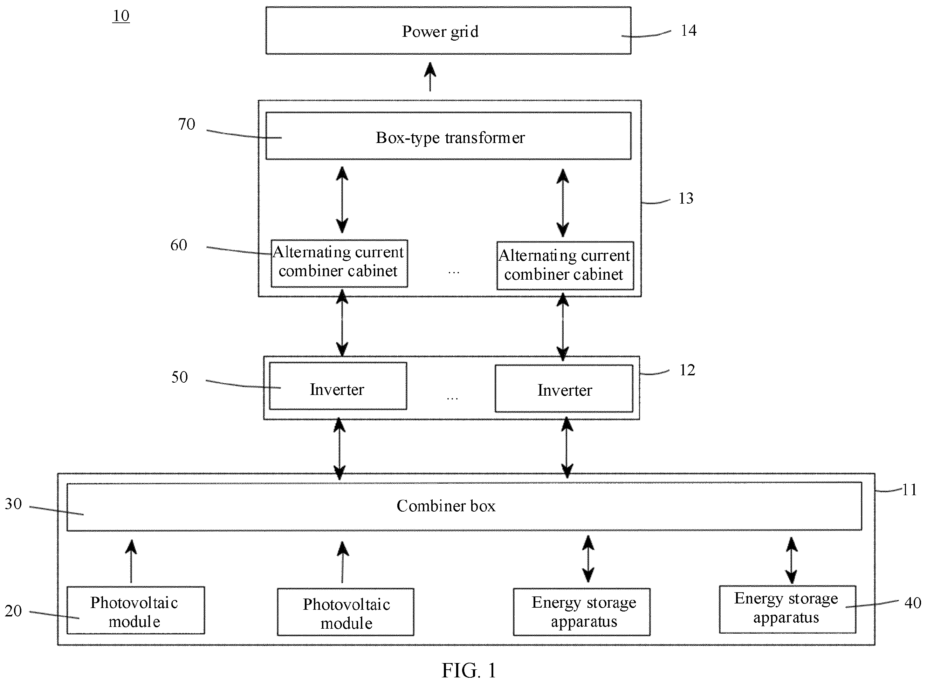

FIG. 1 is a schematic diagram of a structure of a power generation system. The power generation system may be a photovoltaic power generation system or a wind power generation system. Specifically, the photovoltaic power generation system is used as an example in this application. The photovoltaic power generation system is a new type of power generation system which uses a photovoltaic effect of solar cell semiconductor material to convert solar radiation energy into electric energy directly. The photovoltaic power generation system 10 includes a direct current module 11, an inverter module 12, an alternating current module 13, and a power grid 14. The direct current module 11 mainly includes a photovoltaic module 20, a combiner box 30, and an energy storage apparatus 40. The inverter module 12 mainly includes an inverter 50. The alternating current module 13 mainly includes an alternating current combiner cabinet 60 and a box-type transformer substation 70.

A plurality of photovoltaic modules 20 are assembled to form a photovoltaic array, and the photovoltaic array converts light energy into direct current electric energy under the action of photovoltaic effect (the photovoltaic effect refers to a phenomenon that a semiconductor generates an electromotive force when exposed to light) in the presence of light (produced by sunlight or another light emitter), to complete energy conversion. The photovoltaic module 20 usually refers to a solar cell module. Because an output voltage of a single solar cell is low, and an unpackaged battery is easy to disconnect due to environmental factors, a specific quantity of single cells need to be sealed in series or parallel to form the photovoltaic module 20, to avoid corrosion of battery electrodes and interconnected wires. In addition, battery fragmentation is avoided by packaging, and outdoor mounting is facilitated. The photovoltaic module 20 usually includes a high efficiency crystalline silicon solar cell, ultra-white textured reinforced glass, a transparent backplane, and an aluminum alloy frame, and has characteristics of long service life, strong mechanical compression resistance, and the like.

The combiner box 30 means that a user may connect photovoltaic modules 20 of a specific quantity and a same specification in series to form photovoltaic arrays, and then connect several photovoltaic arrays to the combiner box 30. In other words, the direct current electric energy produced by the photovoltaic modules 20 is converged through the combiner box 30 and input to a subsequent apparatus of the photovoltaic power generation system 10. The combiner box 30 may be a combiner box with a tracing function, or may be a combiner box without a tracing function. The combiner box 30 in the photovoltaic power generation system 10 is a connection apparatus that ensures that the photovoltaic modules 20 are sequentially connected and have a current combining function. The combiner box 30 can also ensure that a circuit can be easily cut off during maintenance and inspection of the photovoltaic power generation system 10, and that when the photovoltaic power generation system 10 is faulty, a power-off range is reduced.

The energy storage apparatus 40 is configured to store electric energy, and a commonly used energy storage apparatus 40 includes a battery, a capacitor, and the like. The energy storage apparatus 40 is connected to the combiner box 30. A part of the direct current electric energy transmitted to the combiner box 30 may be directly transmitted to the inverter 50. When an output power of the photovoltaic modules 20 is greater than a maximum output power of the inverter 50, another part of the excessive direct current electric energy transmitted to the combiner box 30 may be transmitted to the energy storage apparatus 40 for storage. When the output power of the photovoltaic modules 20 is less than the maximum output power of the inverter 50, the direct current electric energy of the energy storage apparatus 40 may be transmitted to the inverter 50 through the combiner box 30.

The inverter 50 is a device for converting direct current electric energy into alternating current electric energy. The direct current electric energy transmitted to the combiner box 30 is further transmitted to the inverter 50 and is converted into low-voltage alternating current electric energy through the inverter 50 (a rated voltage of the low-voltage alternating current electric energy output from the inverter 50 is typically 800 V), and the low-voltage alternating current electric energy is transmitted to the alternating current combiner cabinet 60. As an important electrical device inside the photovoltaic power generation system 10, the inverter 50 has complete protection functions, such as direct current bus over-voltage protection, alternating current over-voltage and under-voltage protection, alternating current frequency protection, polarity reverse connection protection, short circuit protection, island coverage protection, over-temperature protection, and direct current overload protection.

The alternating current combiner cabinet 60 is configured to converge the low-voltage alternating current electric energy output from the inverter 50 and transmit the low-voltage alternating current electric energy to the box-type transformer substation 70, to reduce system wiring, facilitate system maintenance, reduce losses, and improve system safety and reliability.

A main function of the box-type transformer substation 70 is to convert the low-voltage alternating current electric energy output from the inverter 50 into medium-voltage alternating current electric energy received by the power grid 14. The box-type transformer substation 70 is connected to the inverter 50 and the power grid 14. Specifically, the box-type transformer substation 70 may be connected to the inverter 50 through the alternating current combiner cabinet 60. The transformer substation 70 raises the rated voltage to a medium voltage. The medium-voltage alternating current produced by the box-type transformer substation 70 can be transmitted to the power grid 14 to supply power to a user. When the power grid 14 does not need to be charged, the alternating current electric energy conducted to the box-type transformer substation 70 is transmitted to the inverter 50. Then, the inverter 50 converts the alternating current electric energy into direct current electric energy, and then transmits the direct current electric energy to the combiner box 30 and the energy storage apparatus 40 in sequence, to store the electric energy in the energy storage apparatus 40.

It should be noted that the photovoltaic power generation system 10 provided in this embodiment is only an implementation of a photovoltaic power generation system. The photovoltaic power generation system 10 may further include another structure. For example, the photovoltaic power generation system 10 may further include a bidirectional DC/DC converter (not shown in FIG. 1). The bidirectional DC/DC converter is located between the combiner box 30 and the energy storage apparatus 40, direct current electric energy transmitted to the combiner box 30 is transmitted to the bidirectional DC/DC converter (the bidirectional DC/DC converter refers to a bidirectional direct current converter, and may control a charging and discharging process of a battery), and is transmitted to the energy storage apparatus 40.

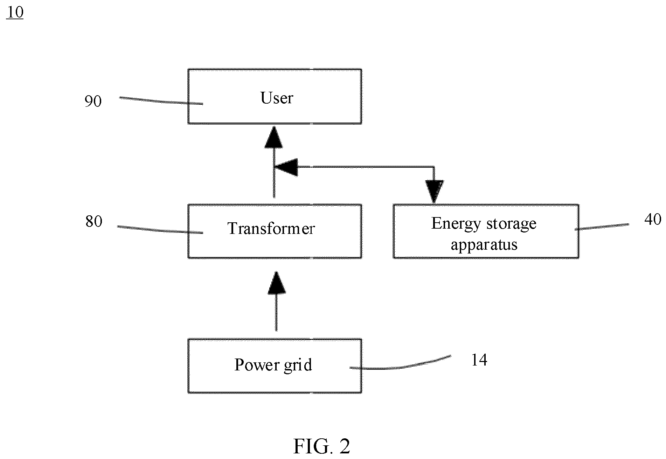

FIG. 2 is a schematic diagram of a structure of another power generation system. The energy storage apparatus 40 shown in FIG. 1 is installed on a power generation side of the photovoltaic power generation system 10, and the energy storage apparatus 40 shown in FIG. 2 is installed on a power consumption side of the photovoltaic power generation system 10. Specifically, refer to FIG. 2. Electric energy transmitted to the power grid 14 is transmitted to the transformer 80. One part of the electric energy is used for supplying power to a user 90, and another part of the electric energy is transmitted to the energy storage apparatus 40 for storage. When necessary, the electric energy in the energy storage apparatus 40 can be transmitted to the user 90 to supply power to the user 90.

It should be noted that, in another implementation, energy storage apparatuses 40 may be disposed on both the power generation side and the power consumption measurement side of the photovoltaic power generation system 10, to resolve a problem of severe intermittent photovoltaic power generation.

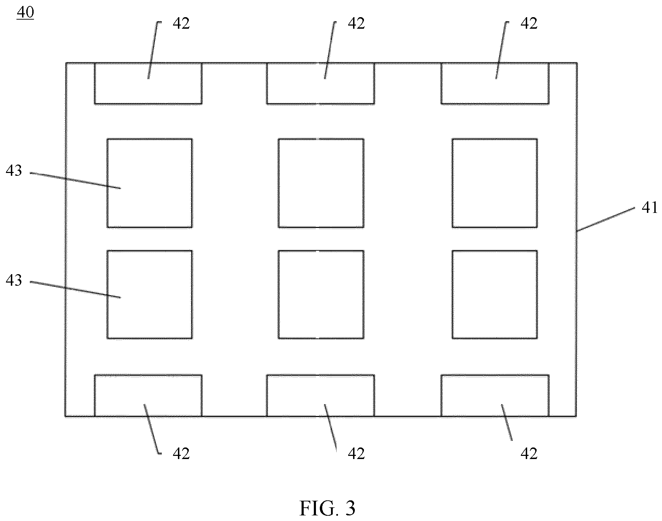

FIG. 3 is a schematic diagram of a structure of the energy storage apparatus 40. The energy storage apparatus 40 includes a housing 41, a temperature control component 42, and an energy storage module 43. Both the temperature control component 42 and the energy storage module 43 are located in the housing 41. The temperature control component 42 may be an air conditioner or another device that is capable of cooling. Cold air produced by the temperature control component 42 is transmitted to the energy storage module 43 to dissipate heat for the energy storage module 43, to prevent an excessively high temperature of the energy storage module 43. The excessively high temperature of the energy storage module 43 may cause a capacity of the energy storage module 43 to decrease. It can be understood that the energy storage apparatus 40 may include a plurality of energy storage modules 43, and the plurality of energy storage modules 43 may be distributed in array in the housing 41.

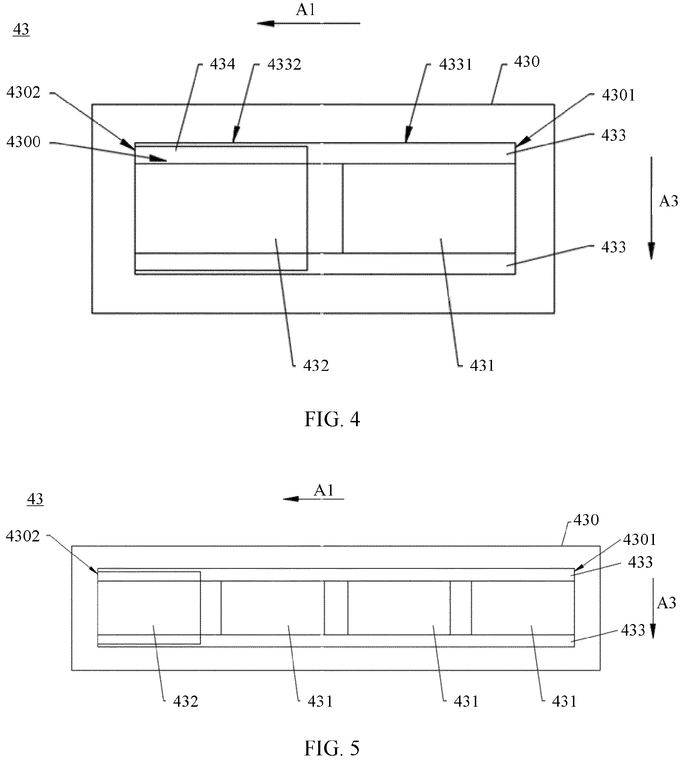

FIG. 4 is a schematic diagram of a structure of the energy storage module 43. The energy storage module 43 includes a housing 430, a first cell 431, a second cell 432, and an air channel mechanical part 433, and the first cell 431, the second cell 432, and the air channel mechanical part 433 are all located in the housing 430.

An air channel 4300 is disposed in the air channel mechanical part 433, and includes an air inlet end 4301 and an air outlet end 4302 that are located at two ends of the air channel 4300. The air channel mechanical part 433 includes a first air channel region 4331 and a second air channel region 4332. The air inlet end 4301 is located in the first air channel region 4331, and the air outlet end 4302 is located in the second air channel region 4332. A heat dissipation part 434 is disposed in the second air channel region 4332, the heat dissipation part 434 is fastened to an inner wall of the second air channel region 4332, and the heat dissipation part 434 is configured to increase a heat dissipation area per unit volume of the second air channel region 4332. In this application, it may also be understood that a region in which the heat dissipation part 434 is disposed becomes the second air channel region 4332, and a region in which no heat dissipation part 434 is disposed becomes the first air channel region 4331.

The first cell 431 and the second cell 432 are disposed outside the air channel mechanical part 433, and are sequentially arranged between the air inlet end 4301 and the air outlet end 4302. Specifically, the first cell 431 is disposed near the air inlet end 4301, and the second cell 432 is disposed near the air outlet end 4302. It may also be understood that the first cell 431 is located between the second cell 432 and the air inlet end 4301. There may be one, two, three, four, five first cells 431, or the like, and there may also be one, two, three, four, five second cells 432, or the like. This is not limited in this application. For example, refer to FIG. 4. There may be one first cell 431 and one second cell 432. Refer to FIG. 5. There may be three first cells 431 and there may be one second cell 432, that is, in the first direction A1, a quantity of first cells 431 may be greater than a quantity of second cells 432. In an actual setting process, when a temperature difference between the second cell 432 and the first cell 431 is greater than a threshold, the heat dissipation part 434 that can increase a heat dissipation area is disposed in the second air channel region 4332 corresponding to the second cell 432. This helps reduce a temperature difference between the second cell 432 and the first cell 431. In this embodiment, the quantity of the first cells 431 is greater than the quantity of the second cells 432, which can reduce a volume of the second air channel region 4332, to reduce manufacturing costs. In another implementation, a quantity of the first cells 431 may also be less than a quantity of the second cells 432.

The first air channel region 4331 is disposed correspondingly with the first cell 431, and the second air channel region 4332 is disposed correspondingly with the second cell 432, that is, the heat dissipation part 434 is disposed correspondingly with the second cell 432. The heat dissipation area per unit volume of the second air channel region 4332 is greater than the heat dissipation area per unit volume of the first air channel region 4331, to reduce the temperature difference between the second cell 432 and the first cell 431. The first air channel region 4331 and the second air channel region 4332 (that is, the air channel mechanical part 433) may be used as an aluminum profile or another air channel mechanical part, and are configured to transmit cold air produced by the temperature control component 42 to the first cell 431 and the second cell 432, to dissipate heat for the first cell 431 and the second cell 432. The heat dissipation part 434 and the second air channel region 4332 may be considered as an integrated structure, which simplifies an assembly process. The heat dissipation part 434 and the second air channel region 4332 may also be considered as a split structure. It should be noted that the heat dissipation part 434 is fastened to the second air channel region 4332, that is, the heat dissipation part 434 is in contact with the second air channel region 4332. To clearly indicate a location relationship between the heat dissipation part 434 and the second air channel region 4332, only one side of the heat dissipation part 434 shown in FIG. 4 and FIG. 5 is in contact with the second air channel region 4332. In other implementation, the heat dissipation part 434 can be set to be of a larger size, and two sides of the heat dissipation part 434 can be in contact with the second air channel region 4332, and the heat dissipation area is larger.

In this implementation, there may be two air channel mechanical parts 433, and the two air channel mechanical parts 433 are respectively located on two opposite sides of the first cell 431. In another implementation, there may also be one air channel mechanical part 433, and one air channel mechanical part 433 is located on one side of the first cell 431.

In this application, the heat dissipation area per unit volume of the second air channel region 4332 is set to be greater than the heat dissipation area per unit volume of the first air channel region 4331, so that a problem of an excessively large temperature difference between the first cell 431 and the second cell 432 can be resolved. Specifically, in a working process of the energy storage module 43, the first cell 431 and the second cell 432 generate heat energy, and generally, the temperature control component 42 is used to dissipate heat for the first cell 431 and the second cell 432. The cold air produced by the temperature control component 42 enters from the air inlet end 4301, passes by the first cell 431 and the second cell 432 in sequence, and takes away heat energy of the first cell 431 and the second cell 432, and then is converted into hot air and transmitted to the air outlet end 4302 for dissipation, implementing a function of heat dissipation for the first cell 431 and the second cell 432. However, when the cold air passes by the first cell 431, the cold air takes away the heat energy of the first cell 431, so that a temperature of the first cell 431 is lowered. At this time, the temperature of the cold air is higher than a temperature of the cold air existing before the cold air passes by the first cell 431, and the temperature of the cold air existing after passing by the first cell 431 is raised. When the cold air continues to be transmitted to the second cell 432, heat energy absorbed for the second cell 432 is less (compared with the heat energy absorbed for the first cell 431). As a result, a temperature of the second cell 432 is higher than the temperature of the first cell 431, which causes a great temperature difference between the first cell 431 and the second cell 432, a high-temperature second cell 432 and a low-temperature first cell 431 have a significant difference in state of healths, and a capacity of the energy storage module 43 is limited by the second cell 432 in a lowest state of health, an excessively large temperature difference between the first cell 431 and the second cell 432 causes the capacity of the energy storage module 43 to be reduced, and consequently, overall benefits of the system are reduced. In other words, the temperature of the first cell 431 closer to the air inlet end 4301 is lower, and the temperature of the second cell 432 closer to the air outlet end 4302 is higher, that is, the temperature of the second cell 432 is higher than the temperature of the first cell 432. When the cold air produced by the temperature control component 42 is transmitted to a corresponding cell by using the air channel mechanical part 433, the cold air dissipates heat for the cell. In this application, the heat dissipation area per unit volume of the second air channel region 4332 corresponding to the second cell 432 is set to be greater than the heat dissipation area per unit volume of the first air channel region 4331, so that effective heat dissipation of the second cell 432 can be implemented, and the temperature difference between the second cell 432 and the first cell 431 can be reduced, maximizing the capacity of the energy storage module 43 and improving energy yields in a life cycle. If it is ensured that the energy yields in the life cycle are the same, and the temperature difference between the first cell 431 and the second cell 432 in the energy storage module 43 is reduced, operating energy consumption may be reduced, and initial investment can be reduced.

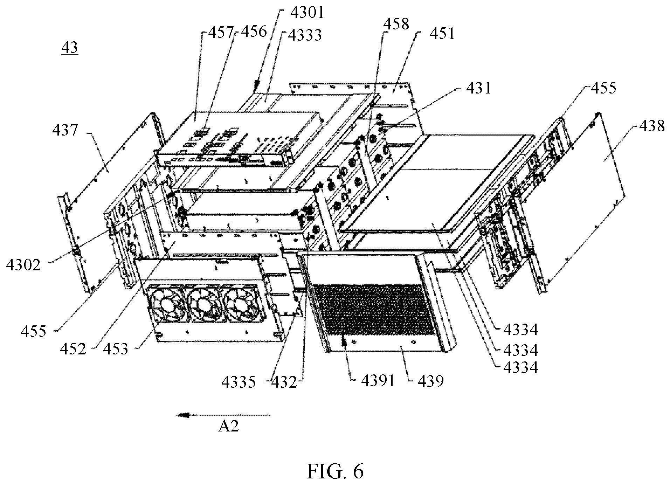

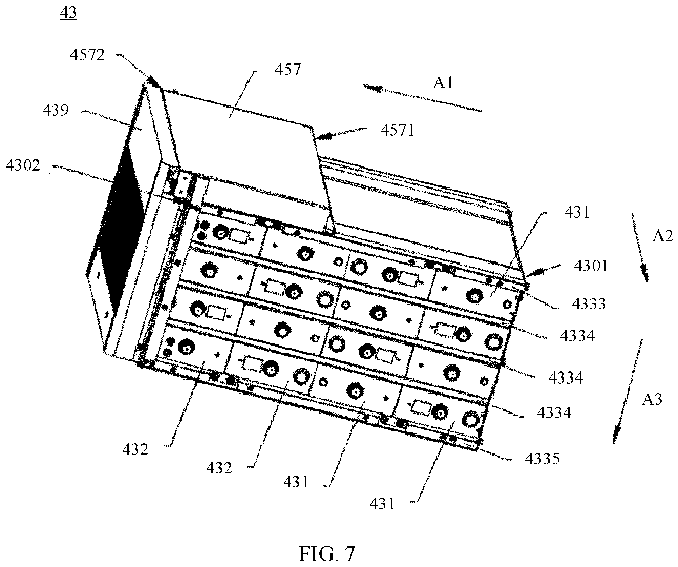

Refer to FIG. 6 and FIG. 7. FIG. 6 is an exploded view of the energy storage module 43, and FIG. 7 is a schematic diagram of a structure of a combined structure of the energy storage module 43. In the energy storage module 43 shown in FIG. 6 and FIG. 7, the first cells 431 and the second cells 432 are arranged as a 4*4 array structure. In this application, an extension direction of the air channel 4300 is a first direction A1, a second direction A2 is perpendicular to the first direction A1, and a third direction A3 is perpendicular to the first direction A1 and is perpendicular to the second direction A2. A first cell 431 and a second cell 432 arranged in the first direction A1 are referred to as one layer of cells, first cells 431 arranged in the third direction A3 are referred to as one row of cells, and second cells 432 arranged in the third direction A3 are referred to as one row of cells.

In this implementation, there may be five air channel mechanical parts 433, which are respectively referred to as a first air channel mechanical part 4333, a second air channel mechanical part 4334, and a third air channel mechanical part 4335 for differentiation, and there are three second air channel mechanical parts 4334. The first air channel mechanical part 4333 is located on an upper side of a first cell 431 and a second cell 432 of an uppermost layer, the third air channel mechanical part 4335 is located on a lower side of a first cell 431 and a second cell 432 at a lowermost layer, and the three second air channel mechanical parts 4334 are separately located between two adjacent layers of cells. The first air channel mechanical part 4333, the second air channel mechanical part 4334, and the third air channel mechanical part 4335 may be fastened between cells of a plurality of layers by using adhesive. When the plurality of first cells 431 and second cells 432 are stacked into a plurality of layers in the third direction A3, a second air channel mechanical part 4334 may be disposed between two adjacent layers of cells to dissipate heat for the first cell 431 and the second cell 432 of the inner layer, or a first air channel mechanical part 4333 and a third air channel mechanical part 4335 may be disposed outside outermost cells to dissipate heat for the first cells 431 and the second cells 432 of the outer layers, and the heat dissipation part 434 is disposed in the second air channel region 4332, to reduce the temperature difference between the first cell 431 and the second cell 432. It may be understood that, when the plurality of first cells 431 and second cells 432 are stacked into the plurality of layers in the third direction A3, temperatures of the first cell 431 and the second cell 432 of the outer layer is lower than temperatures of the first cell 431 and the second cell 432 of the inner layer, affected by an external environment of the energy storage module 43. In this implementation, a second air channel mechanical part 4334 may be disposed between two adjacent layers of cells to dissipate heat for the first cell 431 and the second cell 432 of the inner layer, or a first air channel mechanical part 4333 and a third air channel mechanical part 4335 may be disposed outside outermost cells to dissipate heat for the first cells 431 and the second cells 432 of the outer layers, to reduce a temperature difference between the first cell 431 and the second cell 432 of the inner layer, and the first cell 431 and the second cell 432 of the outer layer. The first cell 431 and the second cell 432 of the inner layer and the first cell 431 and the second cell 432 of the outer layer refer to that, in the third direction A3, two layers of cells respectively located at an uppermost layer and a lowermost layer are the first cells 431 and the second cells 432 of the outer layers, and the first cell 431 and the second cell 432 of the inner layer are located between the first cells 431 and the second cells 432 of the two outer layers.

It should be noted that, the first air channel mechanical part 4333, the second air channel mechanical part 4334, and the third air channel mechanical part 4335 each include a first air channel region 4331 and a second air channel region 4332. An arrangement manner of the first cells 431 and the second cells 432 is not limited to a 4*4 array structure. When at least two first cells 431 are spaced apart in the third direction A3 and at least two second cells 432 are spaced apart in the third direction A3, a first air channel region 4331 is disposed between adjacent first ells 431 in the third direction A3, and a second air channel region 4332 is set between adjacent second cells 432.

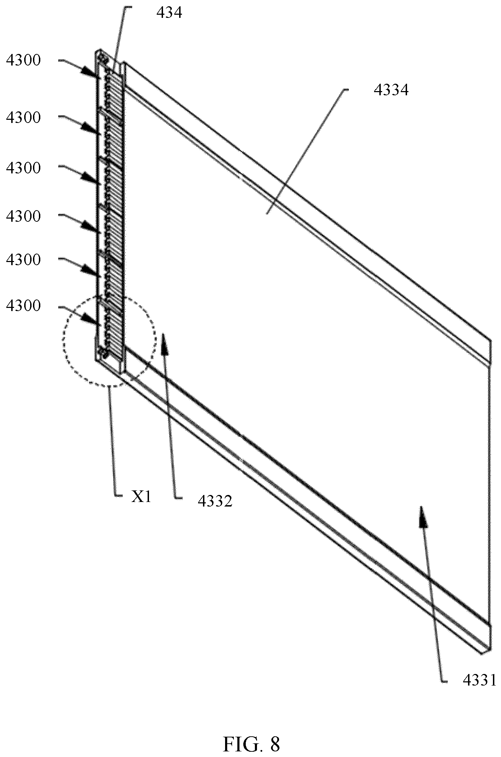

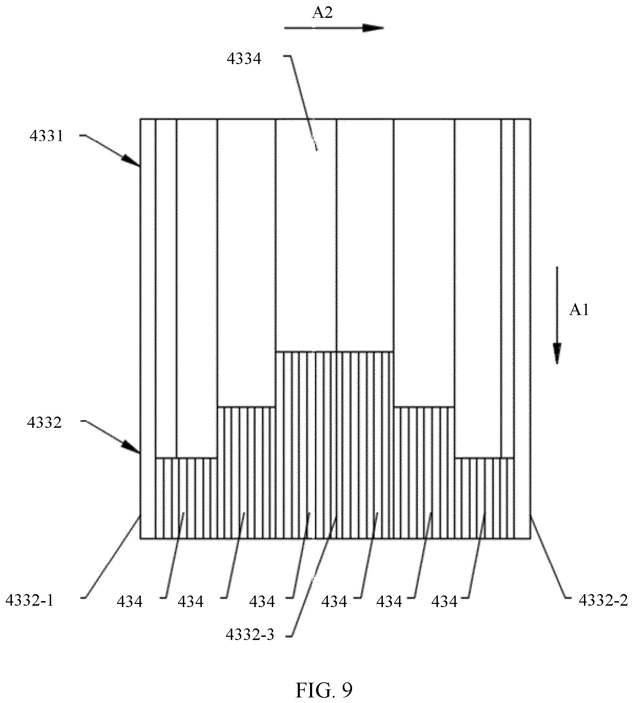

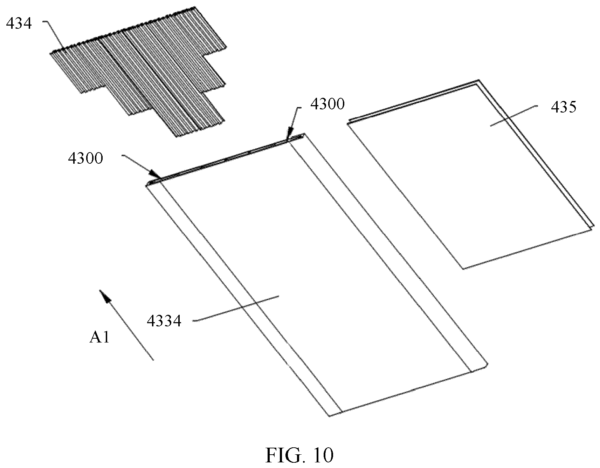

Refer to FIG. 8, FIG. 9, and FIG. 10. FIG. 8 is a schematic diagram of a three-dimensional structure of the second air channel mechanical part 4334, FIG. 9 is a schematic diagram of a planar structure of the second air channel mechanical part 4334, and FIG. 10 is a schematic diagram of a split structure of the second air channel mechanical part 4334. In this embodiment, a structure of the second air channel mechanical part 4334 is used as an example (for heat dissipation structures of the first air channel mechanical part 4333 and the third air channel mechanical part 4335, refer to the second air channel mechanical part 4334, and a difference from the second air channel mechanical part 4334 is that a fastened structure is disposed on the first air channel mechanical part 4333 and the third air channel mechanical part 4335, and the fastened structure is described in detail in the following). The second air channel mechanical part 4334 includes a plurality of air channels 4300, and the heat dissipation part 434 may be embedded in the air channel 4300. There may be a plurality of heat dissipation parts 434. The heat dissipation part 434 is disposed in each air channel 4300. The heat dissipation part 434 may be fastened to an inner wall of the second air channel region 4332 in a welding manner, and the heat dissipation part 434 and the second air channel region 4332 may alternatively be of an integrated structure.

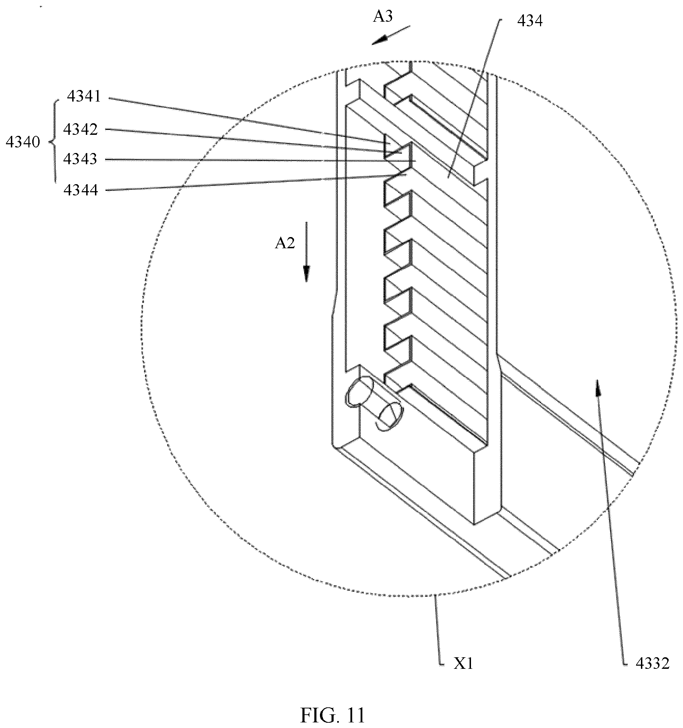

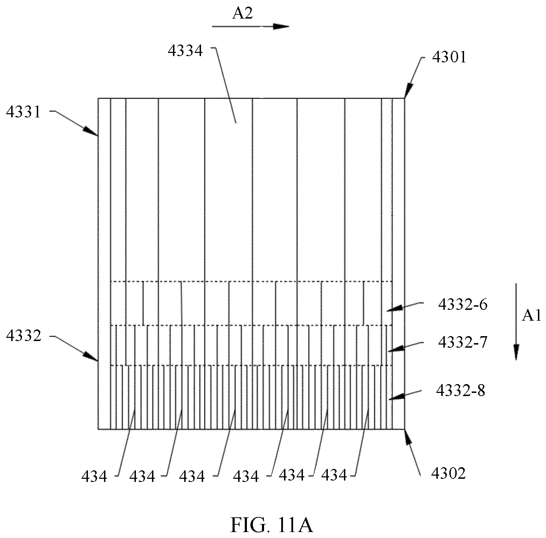

In a specific embodiment, FIG. 11 is an enlarged schematic diagram of a structure shown at X1 in FIG. 8. The heat dissipation part 434 includes a heat dissipation unit 4340, and the heat dissipation unit 4340 includes a first plate 4341, a second plate 4342, a third plate 4343, and a fourth plate 4344 that are sequentially connected. The first plate 4341 and the third plate 4343 are spaced apart in the third direction A3 and are disposed in a staggered manner in the second direction A2. The first plate 4341 is fastened to the inner wall of the second air channel region 4332, or the third plate 4343 is fastened to the inner wall of the second air channel region 4332. When a size of the heat dissipation part 434 in the third direction A3 is large, both the first plate 4341 and the third plate 4343 may be fastened to the inner wall of the second air channel region 4332. The fourth plate 4344 and the second plate 4342 are spaced apart in the second direction A2 and are located on two opposite sides of the third plate 4343. In this implementation, the heat dissipation part 434 may include a plurality of heat dissipation units 4340, and the plurality of heat dissipation units 4340 are successively connected and fastened to the second air channel region 4332 to increase the heat dissipation area of the second air channel region 4332 and reduce the temperature difference between the second cell 432 and the first cell 431, to utilize a maximum capacity of the energy storage module 43.

Refer to FIG. 7 and FIG. 9. The second air channel region 4332 includes a first edge 4332-1, a middle portion 4332-3, and a second edge 4332-2 that are sequentially arranged in the second direction A2. It should be noted that the middle portion 4332-3 is only located between the first edge 4332-1 and the second edge 4332-2 in the second direction A2, and is not limited to a middle position between the first edge 4332-1 and the second edge 4332-2. A plurality of heat dissipation parts 434 are arranged in the second direction A2 and embedded into the second air channel region 4332, and the plurality of heat dissipation parts 434 are located between the first edge 4332-1 and the second edge 4332-2. A length of the heat dissipation part 434 is a size of the heat dissipation part 434 in the first direction A1, lengths of heat dissipation parts 434 between the middle portion 4332-3 and the first edge 4332-1 gradually decrease, and lengths of heat dissipation parts 434 between the middle portion 4332-3 and the second edge 4332-2 gradually decrease, which may also be understood as: A length of a heat dissipation part 434 located in the middle portion 4332-3 is greater than lengths of heat dissipation parts 434 located on the first edge 4332-1 and the second edge 4332-2. The plurality of second cells 432 may be arranged in the second direction A2. In the second direction A2, the second cell 432 near the edge is affected by natural heat dissipation of air around the energy storage module 43 and has a lower temperature (compared with a temperature of the second cell 432 in the middle portion). Therefore, a length of the heat dissipation part 434 on the edge may be set to be less than a length of the heat dissipation part 434 in the middle portion, so that a temperature difference of the plurality of second cells 432 arranged in the second direction A2 can be reduced. In addition, materials of the heat dissipation part 434 can be reduced, and production costs can be reduced.

As shown in FIG. 11A, the second air channel region 4332 includes a first sub-region 4332-6, a second sub-region 4332-7, and a third sub-region 4332-8 that are sequentially distributed in a first direction A1, and an end that is of the third sub-region 4332-8 and that is away from the second sub-region 4332-7 is the air outlet end 4302. A heat dissipation area per unit volume of the third sub-region 4332-8 is greater than a heat dissipation area per unit volume of the second sub-region 4332-7, and the heat dissipation area per unit volume of the second sub-region 4332-7 is greater than a heat dissipation area per unit volume of the first sub-region 4332-6. Specifically, the heat dissipation part 434 may be a heat sink fin, and density of the heat dissipation parts 434 may be gradually increased. In the first direction A1, there may be a plurality of second cells 432, and a second cell 432 closer to the air outlet end 4302 has a higher temperature. The first sub-region 4332-6, the second sub-region 4332-7, and the third sub-region 4332-8 are disposed correspondingly with the plurality of second cells 432. In this implementation, heat dissipation areas per unit volume of the first sub-region 4332-6 to the third sub-region 4332-8 are gradually increased, which helps reduce the temperature difference between the plurality of second cells 432 and the temperature difference between the second cell 432 and the first cell 431.

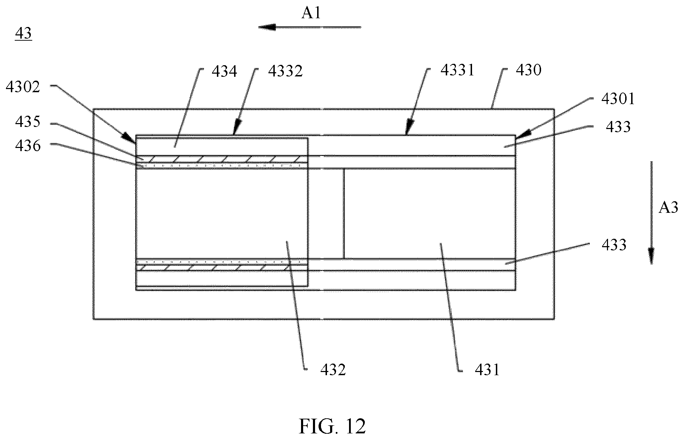

Refer to FIG. 10 and FIG. 12. The energy storage module 43 is provided with a heat-conducting part 435, the heat-conducting part 435 may be disposed between the second air channel region 4332 and the second cell 432, and a heat conductivity coefficient of the heat-conducting part 435 is greater than a heat conductivity coefficient of the air channel mechanical part 433. The heat-conducting part 435 is configured to fast transfer heat energy produced by the second cell 432 to the cold air that passes through the second air channel region 4332, to reduce the temperature of the second cell 432 and reduce the temperature difference between the second cell 432 and the first cell 431. A main function of the heat-conducting part 435 is to conduct heat energy between the second cell 432 and the air channel mechanical part 433. The heat conductivity coefficient of the heat-conducting part 435 is usually high. For example, the air channel mechanical part 433 may be made of aluminum, and the heat-conducting part 435 may be made of copper with a high heat conductivity coefficient to achieve fast heat conduction.

It should be noted that, when the heat-conducting part 435 is disposed between the second air channel region 4332 and the second cell 432, there is a gap between the first air channel region 4331 and the first cell 431, and the gap between the first air channel region 4331 and the first cell 431 may be filled with heat insulation cotton (not shown in FIG. 12), and a heat conductivity effect of the heat insulation cotton is low, heat transfer between the first cell 431 and the first air channel region 4331 can be reduced, and the temperature difference between the first cell 431 and the second cell 432 can be reduced. In addition, the heat insulation cotton can also prevent the first cell 431 from being heated to deform.

To improve the heat conduction capability of the heat-conducting part 435, a phase change medium may be disposed in the heat-conducting part 435. The phase change medium may be water or the like. Specifically, the heat-conducting part 435 may be a heat pipe, a temperature equalizing plate, or the like. A capillary structure (not shown in FIG. 12) may be further disposed in the heat-conducting part 435. The capillary structure is located on an inner wall of the heat-conducting part 435, and the phase change medium is located in a cavity of the heat-conducting part 435. Heat is absorbed in a region in the heat-conducting part in which the heat-conducting part 435 is in contact with the second cell 432 (the heat-conducting part 435 may be directly in contact with the second cell 432, and the heat-conducting part 435 may alternatively be indirectly in contact with the second cell 432), so that the phase change medium in the heat-conducting part 435 is heated and gasified, that is, water changes from a liquid state to a gas, and the gas flows to another region in the cavity of the heat-conducting part 435. In a region in the heat-conducting part 435 in which the heat-conducting part 435 is in contact with the second air channel region 4332, because a temperature is low, the gas is liquefied into a liquid, and heat energy is released at the same time. The heat energy is conducted to the second air channel region 4332. The liquid is adsorbed on the capillary structure and transmitted to the second cell 432 side by using the capillary structure. In this way, a gas-liquid two-phase cycle is formed, and heat energy is fast conducted, improving heat-conducting efficiency of the heat-conducting part 435.

Refer to FIG. 12, an elastic member 436 is disposed between the heat-conducting part 435 and the second cell 432, and the elastic member 436 is configured to fill a gap between the heat-conducting part 435 and the second cell 432. It may be understood that an elastic member 436 (not shown in FIG. 12) may also be disposed between the heat-conducting part 435 and the second air channel region 4332, and the elastic member 436 is configured to fill a gap between the heat-conducting part 435 and the second air channel region 4332. The elastic member 436 may be graphite foam, a phase change film, a liquid metal, silicone thermal grease, or thermal gel. One side of the heat-conducting part 435 is connected to the second cell 432, and the other side of the heat-conducting part 435 is connected to the second air channel region 4332. Elastic members 436 may be disposed between the heat-conducting part 435 and the second cell 432 and between the heat-conducting part 435 and the second air channel region 4332. The elastic members 436 are configured to fill a gap between the heat-conducting part 435 and the second cell 432 and between the heat-conducting part 435 and the second air channel region 4332, to improve heat dissipation efficiency.

Specifically, the heat-conducting part 435 and the second cell 432 are used as an example. In one aspect, the heat-conducting part 435 may not be in full contact with the second cell 432 due to existence of a mechanical tolerance, in another aspect, when the heat-conducting part 435 and the second cell 432 are in contact with each other, even if surface flatness of the heat-conducting part 435 and the second cell 432 is good, close contact cannot be achieved, and only partial contact can be achieved. There are still many extremely small gaps or holes between the two materials, and a heat conductivity coefficient of air in the gaps is low, which increases heat resistance, a heat conduction path is blocked. Therefore, the elastic member 436 is filled between the heat-conducting part 435 and the second cell 432, the gap between the heat-conducting part 435 and the second cell 432 can be filled, air in the gap can be removed, heat resistance is reduced, and heat energy transfer efficiency is improved. In other words, the heat-conducting part 435 and the second cell 432 may be in a close contact connection with each other by pressing the elastic member 436, to avoid a problem that heat dissipation efficiency is reduced because the heat-conducting part 435 cannot be in a close contact connection to the second cell 432 due to a specific mechanical tolerance and surface roughness.

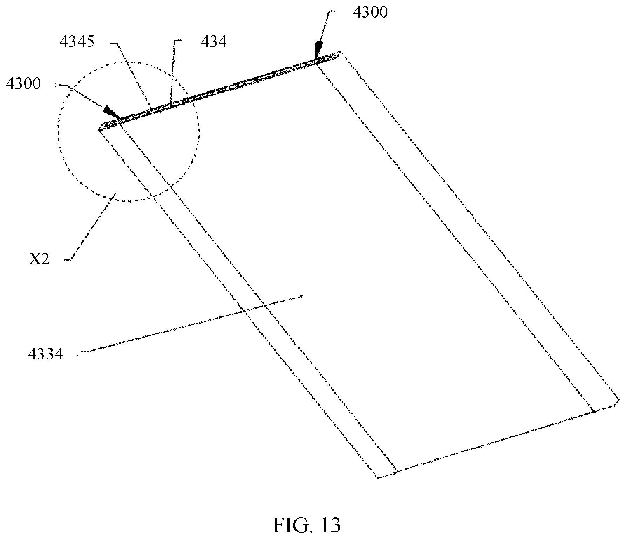

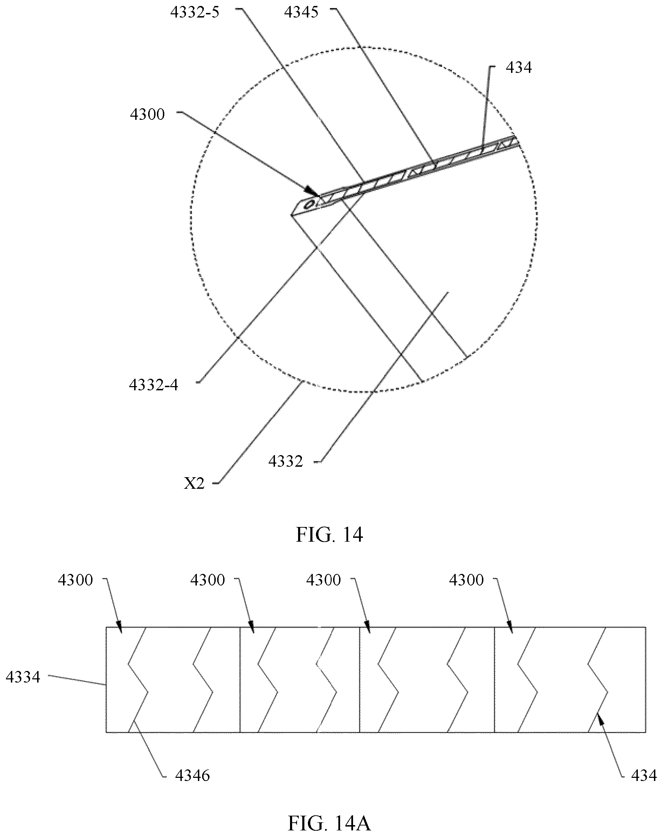

In a specific embodiment, refer to FIG. 13 and FIG. 14. FIG. 13 is a schematic diagram of a structure of the second air channel mechanical part 4334, and FIG. 14 is an enlarged schematic diagram of a structure shown at X2 in FIG. 13. The second air channel region 4332 includes a top 4332-4 and a bottom 4332-5 that are disposed in the third direction A3, the heat dissipation part 434 includes a plurality of heat sink fins 4345, the heat sink fins 4345 are located in the air channel 4300, and the heat sink fins 4345 are fastened to the top 4332-4 or the bottom 4332-5. There may be a plurality of heat sink fins 4345, the plurality of heat sink fins 4345 are spaced apart in the air channel 4300, one end of the heat sink fin 4345 is fastened to the top 4332-4 of the second air channel region 4332, and the other end of the heat sink fin 4345 is fastened to the bottom 4332-5 of the second air channel region 4332, or when the heat sink fin 4345 has a small size, the heat sink fin 4345 cannot press against the top 4332-4 and the bottom 4332-5 of the second air channel region 4332. The heat sink fin 4345 may be fastened to the top 4332-4 or the bottom 4332-5. In this implementation, a heat dissipation area of the second air channel region 4332 is increased by disposing the heat sink fin 4345, which is conducive to heat dissipation of the second cell 432, to reduce a temperature difference between the second cell 432 and the first cell 431, and maximize the capacity of the energy storage module 43.

As shown in FIG. 14A, the heat dissipation part 434 includes a plurality of bent plates 4346, and the plurality of bent plates 4346 are spaced apart in an air channel 4300. The bent plate 4346 can effectively increase the heat dissipation area per unit volume of the second air channel region 4332, facilitating heat dissipation of the second cell 432, reducing the temperature difference between the second cell 432 and the first cell 431, and maximizing utilization of the capacity of the energy storage module 43.

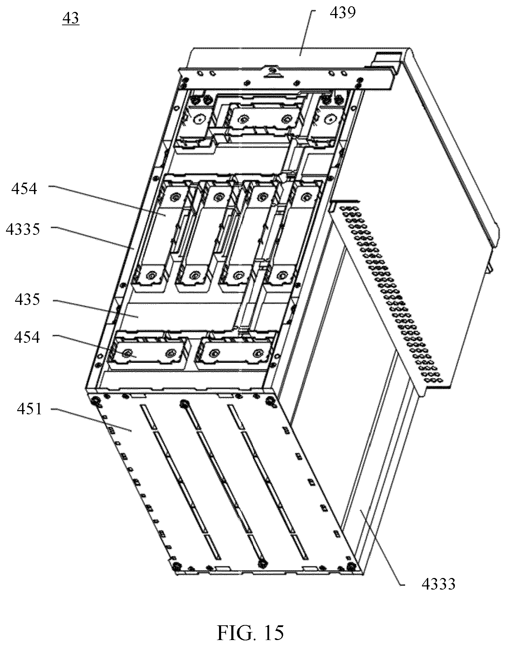

Refer to FIG. 6, FIG. 7, and FIG. 15. The energy storage module 43 is provided with a first side panel 437, a second side panel 438, a front panel 439, an air inlet panel 451, an air outlet panel 452, an air control component 453, a busbar 454, an insulation cover plate 455, a single plate 456, a single plate box 457, and a fastener 458. The first side panel 437, the front panel 439, the second side panel 438, and the air inlet panel 451 are sequentially connected and encircled to form a side portion of the housing 430.

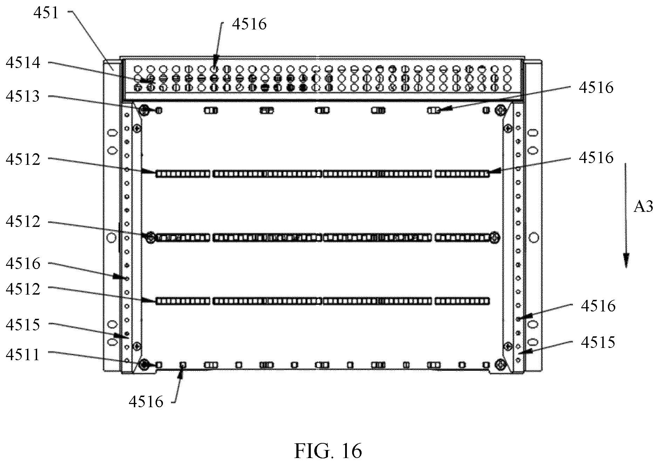

Refer to FIG. 6 and FIG. 16. FIG. 16 is a schematic diagram of a structure of an air inlet panel 451. A structure of the air outlet panel 452 may be the same as a structure of the air inlet panel 451. In this embodiment, the structure of the air inlet panel 451 is used as an example. The air inlet panel 451 is located at the air inlet end 4301. The air inlet panel 451 includes a first hole region 4511, a second hole region 4512, a third hole region 4513, a single plate hole region 4514, and a side hole region 4515 that is disposed at an included angle with the first hole region 4511 that are sequentially arranged in the third direction A3. Specifically, there may be two side hole regions 4515 and the side hole regions 4515 may be spaced apart, and the first hole region 4511 may be vertically disposed with the side hole region 4515.

A plurality of air inlet holes 4516 are disposed in the first hole region 4511, the second hole region 4512, the third hole region 4513, the side hole region 4515, and the single board hole region 4514. The air inlet hole 4516 in the first hole region 4511 is in communication with a third air channel mechanical part 4335, and cold air enters the third air channel mechanical part 4335 through the air inlet hole 4516 in the first hole region 4511; the air inlet hole 4516 in the second hole region 4512 is in communication with a second air channel mechanical part 4334, and cold air enters the second air channel mechanical part 4334 through the air inlet hole 4516 in the second hole region 4512; and the air inlet hole 4516 in the third hole region 4513 is in communication with the first air channel mechanical part 4333, and cold air enters the first air channel mechanical part 4333 through the air inlet hole 4516 in the third hole region 4513. A quantity of air inlet holes 4516 in the second hole region 4512 is greater than a quantity of air inlet holes 4516 in the first hole region 4511 and is greater than a quantity of air inlet holes 4516 in the third hole region 4513, or a size of an air inlet hole 4516 in the second hole region 4512 is greater than a size of an air inlet hole 4516 in the first hole region 4511 and is greater than a size of an air inlet hole 4516 in the third hole region 4513. It should be noted that, in an example in which the air inlet hole 4516 is a circular hole, the size of the air inlet hole 4516 is a diameter of the air inlet hole 4516, and specifically, an area of the air inlet hole 4516. In an example in which the air inlet hole 4516 is a rectangular, square, or another shape, the size of the air inlet hole 4516 is an area of the air inlet hole 4516. Cold air entering through the first hole region 4511 and the third hole region 4513 is used to dissipate heat for the first cell 431 and the second cell 432 of the outer layer, and cold air entering through the second hole region 4512 is used to dissipate heat for the first cell 431 and the second cell 432 of the inner layer. The first cell 431 and the second cell 432 of the outer layer are at a temperature lower than a temperature of the first cell 431 and the second cell 432 of the inner layer, in contact with environment outside the energy storage module 43. Therefore, the first cell 431 and the second cell 432 of the outer layer do not need excessive cold air. In this way, the quantity of air inlet holes 4516 in the second hole region 4512 may be set to be greater than the quantity of air inlet holes 4516 in the first hole region 4511 and greater than the quantity of air inlet holes 4516 in the third hole region 4513, or the size of the air inlet hole 4516 in the second hole region 4512 is greater than the size of the air inlet hole 4516 in the first hole region 4511 and greater than the size of the air inlet hole 4516 in the third hole region 4513, so that more cold air passes through the air inlet hole 4516 in the second hole region 4512 to dissipate heat for the first cell 431 and the second cell 432 of the inner layer, to reduce the temperature differences between the first cell 431 and the second cell 432 of the inner layer, and the first cell 431 and the second cell 432 of the outer layer.

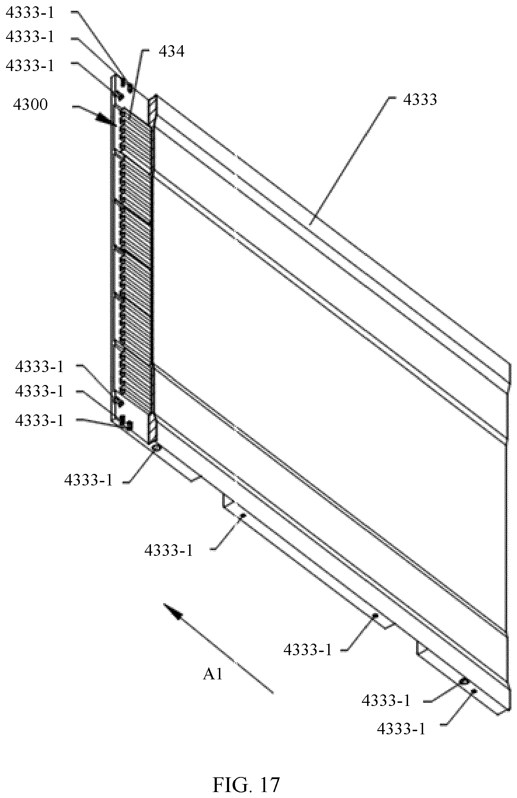

FIG. 17 is a schematic diagram of a structure of the first air channel mechanical part 4333. A structure of the third air channel mechanical part 4335 is the same as a structure of the first air channel mechanical part 4333, and the structure of the first air channel mechanical part 4333 is used as an example herein. It should be noted that, for heat dissipation structures such as the air channel 4300 and the heat dissipation part 434 of the first air channel mechanical part 4333, refer to the second air channel mechanical part 4334. A difference between the first air channel mechanical part 4333 and the second air channel mechanical part 4334 is that the first air channel mechanical part 4333 is provided with a fastened structure. Specifically, a plurality of installation holes 4333-1 are disposed on the first air channel mechanical part 4333 (correspondingly, a plurality of installation holes are also disposed on the third air channel mechanical part 4335).

With reference to FIG. 6 and FIG. 17, the fasteners 458 are fastened to the installation holes 4333-1 of the first air channel mechanical part 4333 and the installation holes of the third air channel mechanical part 4335 by using screws, bolts, or the like (the fastener 458 is fastened to a side portion of the first air channel mechanical part 4333 that extends in the first direction A1), and the fasteners 458 are fastened to the first air channel mechanical part 4333 and the third air channel mechanical part 4335, to tighten the cells of a plurality of layers in the third direction A3, implementing stable installation of the cells.

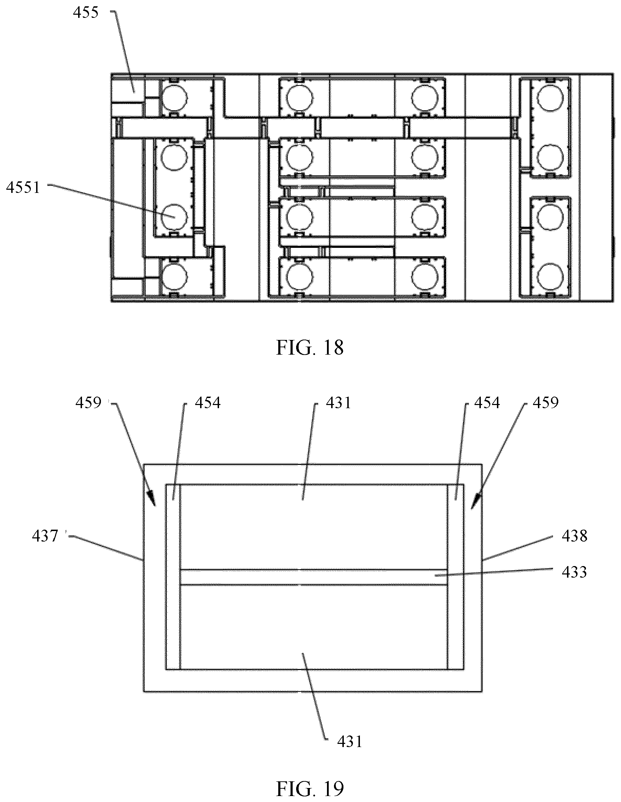

Refer to FIG. 6 and FIG. 18. FIG. 18 is a schematic diagram of a structure of an insulation cover board 455. The insulation cover board 455 is located at the side portion of the first air channel mechanical part 4333 extending in the first direction A1, and the insulation cover board 455 is connected between the first cell 431 and the busbar 454 and between the second cell 432 and the busbar 454. Through holes 4551 are provided on the insulation cover board 455, and poles (not shown in the figure) of the first cell 431 and the second cell 432 are electrically connected to the busbar 454 through the through holes 4551. The insulation cover board 455 is configured to fasten the busbar 454 to the first cell 431 and the second cell 432. Currents of the plurality of first cells 431 and second cells 432 converge to the busbar 454, and the busbar 454 performs a function of converging current converging.

With reference to FIG. 6 and FIG. 19. The first side panel 437 and the second side panel 438 are distributed on two opposite sides of the first air channel mechanical part 4333, and the first side panel 437 and the second side panel 438 are arranged in the second direction A2. It may be understood that, the first side panel 437, the first cell 431, and the second side panel 438 are spaced in a second direction, and the busbar 454 is fastened to a side that is of the first cell 431 and the second cell 432 and that faces on one side of the first side panel 437 or faces one side of the second side panel 438. The first side panel 437 and the second side panel 438 are fastened to the installation holes 4333-1 of the first air channel mechanical part 4333 and the installation holes of the third air channel mechanical part 4335 by using screws and bolts. There is a gap 459 between the first side panel 437 and the busbar 454 and a gap 459 between the second side panel 438 and the busbar 454. Currents produced by the first cells 431 and the second cells 432 are converged to the busbar 454, and are transmitted to an electrode of the energy storage module 43. In a current transmission process, the busbar 454 generates heat energy. The gaps 459 are provided between the busbar 454 and the side panels, cold air may dissipate heat for the busbar 454 through the gaps 459 between the busbar 454, and the first side panel 437 and the second side panel 438. The cold air can also dissipate heat for the first cell 431 and the second cell 432 from the gaps 459, which can effectively reduce the temperature inside the energy storage module 43.

With reference to FIG. 16 and FIG. 19. The side hole region 4515 is corresponding to the gap 459, and the cold air enters the gap 459 through the air inlet hole 4516 of the side hole region 4515 for dissipating heat for the first cell 431, the second cell 432, and the busbar 454, effectively reducing a temperature inside the energy storage module 43.

A structure of the air outlet panel 452 is the same as a structure of the air inlet panel 451. The air outlet holes on the air outlet panel 452 communicate with air outlet ends 4302 of the first air channel mechanical part 4333, the second air channel mechanical part 4334, and the third air channel mechanical part 4335. The air outlet panel 452 is fastened to the first air channel mechanical part 4333 and the third air channel mechanical part 4335. The air control component 453 is disposed between the air outlet panel 452 and the front panel 439. The air control component 453 is located at the air outlet end 4302, the air channel mechanical part 433 communicates with the air control component 453, the air control component 453 may be a fan, and the air control component 453 is configured to extract hot air that absorbs heat energy of the first cell 431 and the second cell 432 and dissipate the hot air through a heat dissipation hole 4391 on the front panel 439.

With reference to FIG. 6 and FIG. 7, the single board box 457 is located on a side of the first air channel mechanical part 4333 away from the first cell 431, and the single board 456 is located in the single board box 457. The single board box 457 includes an air inlet side 4571 and an air outlet side 4572. The air outlet side 4572and the air control component 453 are used to dissipate heat for the single plate 456. Cold air enters from the air inlet side 4571 and dissipates heat for the single plate 456 and exits from the air outlet side 4572. In this implementation, the single plate 456, the first cell 431, and the second cell 432 share one air control component 453, which can reduce production costs, reduce internal space of the energy storage module 43, and implement miniaturization of the energy storage module 43. The single plate 456 is a battery management module, and may be configured to collect data such as temperatures and voltages of the first cell 431 and the second cell 432.

In this application, a heat dissipation area per unit volume of a second air channel region 4332 is set to be greater than a heat dissipation area per unit volume of a first air channel region 4331, so that effective heat dissipation of a second cell 432 is implemented, and a temperature difference between the second cell 432 and a first cell 431 is reduced, to maximize utilization of a capacity of an energy storage module 43.

Example embodiments of this application are described above. It should be noted that a person of ordinary skill in the may further make several improvements and modifications without departing from the scope of the invention that is defined by the appended claims.

## Claims

1. An energy storage module (43), comprising a first cell (431), a second cell (432), and an air channel mechanical part (433, 4333, 4334, 4335), wherein an air channel (4300) is disposed inside the air channel mechanical part (433, 4333, 4334, 4335), the air channel mechanical part (433, 4333, 4334, 4335) comprises an air inlet end (4301) and an air outlet end (4302) that are located at two ends of the air channel (4300), the first cell (431) and the second cell (432) are disposed outside the air channel mechanical part (433, 4333, 4334, 4335) and are sequentially arranged between the air inlet end (4301) and the air outlet end (4302), wherein the first cell (431) is located between the second cell (432) and the air inlet end (4301), the air channel mechanical part (433, 4333, 4334, 4335) comprises a first air channel region (4331) and a second air channel region (4332), wherein the air inlet end (4301) is located in the first air channel region (4331) and the air outlet end (4302) is located in the second air channel region (4332), the first air channel region (4331) is disposed correspondingly with the first cell (431), the second air channel region (4332) is disposed correspondingly with the second cell (432), and a heat dissipation area per unit volume of the second air channel region (4332) is greater than a heat dissipation area per unit volume of the first air channel region, to reduce a temperature difference between the second cell (432) and the first cell (431), wherein the air channel mechanical part (433, 4333, 4334, 4335) comprises a heat dissipation part (434), the heat dissipation part (434) is fastened to an inner wall of the second air channel region (4332), and the heat dissipation part (434) is configured to increase the heat dissipation area per unit volume of the second air channel region (4332).

2. The energy storage module (43) according to claim 1, wherein an extension direction of the air channel (4300) is a first direction (A1), a second direction (A2) is perpendicular to the first direction (A1), and in the second direction (A2), the second air channel region (4332) comprises a middle portion (4332-3) and edges (4332-1, 4332-2) located on two sides of the middle portion (4332-3), a length that is of the heat dissipation part (434) and that is in the middle portion (4332-3) is greater than a length that is of the heat dissipation part (434) and that is on the edge (4332-1, 4332-2), and the length is an extension size of the heat dissipation part (434) in the first direction (A1).

3. The energy storage module (43) according to claim 1, wherein an extension direction of the air channel (4300) is a first direction (A1), the second air channel region (4332) comprises a first sub-region (4332-6), a second sub-region (4332-7), and a third sub-region (4332-8) that are sequentially distributed in the first direction (A1), an end that is of the third sub-region (4332-8) and that is away from the second sub-region (4332-7) is the air outlet end (4302), a heat dissipation area per unit volume of the third sub-region (4332-8) is greater than a heat dissipation area per unit volume of the second sub-region (4332-7), and the heat dissipation area per unit volume of the second sub-region (4332-7) is greater than a heat dissipation area per unit volume of the first sub-region (4332-6).

4. The energy storage module (43) according to any one of claims 1 to 3, wherein a quantity of arranged first cells (431) is greater than a quantity of arranged second cells (432) in the extension direction of the air channel (4300).

5. The energy storage module (43) according to claim 1, wherein the heat dissipation part (434) comprises a first plate (4341), a second plate (4342), a third plate (4343), and a fourth plate (4344) that are sequentially connected, the second plate (4342) and the fourth plate (4344) are spaced apart in a second direction (A2), the first plate (4341) and the third plate (4343) are disposed in a staggered manner in the second direction (A2), and the second direction (A2) is perpendicular to an extension direction of the air channel (4300).

6. The energy storage module (43) according to claim 1, wherein the heat dissipation part (434) comprises a heat sink fin (4345), and the heat sink fin (4345) is fastened to the inner wall of the second air channel region (4332).

7. The energy storage module (43) according to claim 1, wherein the heat dissipation part (434) comprises a bent plate (4346), and the bent plate (4346) is fastened to the inner wall of the second air channel (4300).

8. The energy storage module (43) according to any one of claims 1 to 7, wherein the energy storage module (43) comprises a heat-conducting part (435), and the heat-conducting part (435) is located between the second air channel region (4332) and the second cell (432).

9. The energy storage module (43) according to claim 1, wherein at least two first cells (431) are spaced apart in a third direction (A3), at least two second cells (432) are spaced apart in the third direction (A3), and in the third direction (A3), the first air channel region (4331) is disposed between adjacent first cells (431), the second air channel region (4332) is disposed between adjacent second cells (432), and the third direction (A3) is perpendicular to an extension direction of the air channel (4300).

10. The energy storage module (43) according to claim 9, wherein the air inlet end (4301) is provided with an air inlet panel (451), the air inlet panel (451) is provided with a first hole region (4511), a second hole region (4512), and a third hole region (4513) that are sequentially arranged in the third direction (A3), the first hole region (4511), the second hole region (4512), and the third hole region (4513) are all provided with air inlet holes (4516) and in communication with the air channel mechanical part (433, 4333, 4334, 4335), and a quantity of air inlet holes (4516) in the second hole region (4512) is greater than a quantity of air inlet holes (4516) in the first hole region (4511) and greater than a quantity of air inlet holes (4516) in the third hole region (4513), or a size of the air inlet hole (4516) in the second hole region (4512) is greater than a size of the air inlet (4516) hole in the first hole region (4511) and greater than a size of the air inlet hole (4516) in the third hole region (4513).

11. The energy storage module (43) according to claim 10, wherein the energy storage module (43) comprises a side panel (437, 438) and a busbar (454), the side panel (437, 438) and the first cell (431) are spaced apart in a second direction (A2), the second direction (A2) is perpendicular to an extension direction of the air channel (4300), the busbar (454) is fastened to a side that is of the first cell (431) and that faces the side panel (437, 438), there is a gap (459) between the busbar (454) and the side panel (437, 438), the air inlet panel (451) is provided with a side hole region (4515), the side hole region (4515) and the first hole region (4511) are disposed at an included angle, and an air inlet hole (4516) of the side hole region (4515) is in communication with the gap (459).

12. The energy storage module (43) according to claim 1, wherein the energy storage module (43) comprises a single plate box (457) and a single plate (456) located in the single plate box (457), the air outlet end (4302) is provided with an air control component (453), the air channel mechanical part (433, 4333, 4334, 4335) is in communication with the air control component (453), the single plate box (457) is provided with an air outlet side (4571), the air outlet side (4571) is in communication with the air control component (453), and the air control component (453) is configured to dissipate heat for the single plate (456).

13. An energy storage apparatus (40), comprising a housing (41), a temperature control component (42), and the energy storage module (43) according to any one of claims 1 to 12, wherein both the energy storage module (43) and the temperature control component (42) are located in the housing (41), and the temperature control component (42) is configured to dissipate heat for the energy storage module (43).

14. A power generation system (10), comprising a transformer (80) and the energy storage apparatus (40) according to claim 13, wherein the energy storage apparatus (40) is connected to the transformer (80).

## Patentansprüche

1. Energiespeichermodul (43), das eine erste Zelle (431), eine zweite Zelle (432) und einen mechanischen Luftkanalteil (433, 4333, 4334, 4335) umfasst, wobei im mechanischen Luftkanalteil (433, 4333, 4334, 4335) ein Luftkanal (4300) angeordnet ist, der mechanische Luftkanalteil (433, 4333, 4334, 4335) ein Lufteinlassende (4301) und ein Luftauslassende (4302) umfasst, die bei zwei Enden des Luftkanals (4300) angeordnet sind, die erste Zelle (431) und die zweite Zelle (432) außerhalb des mechanischen Luftkanalteils (433, 4333, 4334, 4335) angeordnet sind und zwischen dem Lufteinlassende (4301) und dem Luftauslassende (4302) sequenziell angeordnet sind, wobei die erste Zelle (431) sich zwischen der zweiten Zelle (432) und dem Lufteinlassende (4301) befindet, der mechanische Luftkanalteil (433, 4333, 4334, 4335) einen ersten Luftkanalbereich (4331) und einen zweiten Luftkanalbereich (4332) umfasst, wobei das Lufteinlassende (4301) sich im ersten Luftkanalbereich (4331) befindet und das Luftauslassende (4302) sich im zweiten Luftkanalbereich (4332) befindet, der erste Luftkanalbereich (4331) der ersten Zelle (431) entsprechend angeordnet ist, der zweite Luftkanalbereich (4332) der zweiten Zelle (432) entsprechend angeordnet ist und eine Wärmeabführfläche pro Volumeneinheit des zweiten Luftkanalbereichs (4332) größer als eine Wärmeabführfläche pro Volumeneinheit des ersten Luftkanalbereichs ist, um eine Temperaturdifferenz zwischen der zweiten Zelle (432) und der ersten Zelle (431) zu verringern, wobei der mechanische Luftkanalteil (433, 4333, 4334, 4335) einen Wärmeabführteil (434) umfasst, der Wärmeabführteil (434) an einer Innenwand des zweiten Luftkanalbereichs (4332) befestigt ist und der Wärmeabführteil (434) konfiguriert ist, die Wärmeabführfläche pro Volumeneinheit des zweiten Luftkanalbereichs (4332) zu erhöhen.

2. Energiespeichermodul (43) nach Anspruch 1, wobei eine Ausdehnungsrichtung des Luftkanals (4300) eine erste Richtung (A1) ist, eine zweite Richtung (A2) zur ersten Richtung (A1) senkrecht ist und in der zweiten Richtung (A2) der zweite Luftkanalbereich (4332) einen Mittelabschnitt (4332-3) und Kanten (4332-1, 4332-2), die sich auf zwei Seiten des Mittelabschnitts (4332-3) befinden, umfasst, eine Länge, die vom Wärmeabführteil (434) stammt und die im Mittelabschnitt (4332-3) liegt, größer als eine Länge ist, die vom Wärmeabführteil (434) stammt und die an der Kante (4332-1, 4332-2) liegt, und die Länge eine Ausdehnungsgröße des Wärmeabführteils (434) in der ersten Richtung (A1) ist.

3. Energiespeichermodul (43) nach Anspruch 1, wobei eine Ausdehnungsrichtung des Luftkanals (4300) eine erste Richtung (A1) ist, der zweite Luftkanalbereich (4332) einen ersten Unterbereich (4332-6), einen zweiten Unterbereich (4332-7) und einen dritten Unterbereich (4332-8), die in der ersten Richtung (A1) sequenziell verteilt sind, umfasst, ein Ende, das vom dritten Unterbereich (4332-8) stammt und das vom zweiten Unterbereich (4332-7) entfernt ist, das Luftauslassende (4302) ist, eine Wärmeabführfläche pro Volumeneinheit des dritten Unterbereichs (4332-8) größer als eine Wärmeabführfläche pro Volumeneinheit des zweiten Unterbereichs (4332-7) ist und die Wärmeabführfläche pro Volumeneinheit des zweiten Unterbereichs (4332-7) größer als eine Wärmeabführfläche pro Volumeneinheit des ersten Unterbereichs (4332-6) ist.

4. Energiespeichermodul (43) nach einem der Ansprüche 1 bis 3, wobei in der Ausdehnungsrichtung des Luftkanals (4300) eine Anzahl angeordneter erster Zellen (431) größer als eine Anzahl angeordneter zweiter Zellen (432) ist.

5. Energiespeichermodul (43) nach Anspruch 1, wobei der Wärmeabführteil (434) eine erste Platte (4341), eine zweite Platte (4342), eine dritte Platte (4343) und eine vierte Platte (4344) umfasst, die sequenziell verbunden sind, die zweite Platte (4342) und die vierte Platte (4344) in einer zweiten Richtung (A2) beabstandet sind, die erste Platte (4341) und die dritte Platte (4343) in einer gestaffelten Weise in der zweiten Richtung (A2) angeordnet sind und die zweite Richtung (A2) zu einer Ausdehnungsrichtung des Luftkanals (4300) senkrecht ist.

6. Energiespeichermodul (43) nach Anspruch 1, wobei der Wärmeabführteil (434) eine Kühlkörperlamelle (4345) umfasst und die Kühlkörperlamelle (4345) an der Innenwand des zweiten Luftkanalbereichs (4332) befestigt ist.

7. Energiespeichermodul (43) nach Anspruch 1, wobei der Wärmeabführteil (434) eine gebogene Platte (4346) umfasst und die gebogene Platte (4346) an der Innenwand des zweiten Luftkanals (4300) befestigt ist.

8. Energiespeichermodul (43) nach einem der Ansprüche 1 bis 7, wobei das Energiespeichermodul (43) einen wärmeleitenden Teil (435) umfasst und der wärmeleitende Teil (435) sich zwischen dem zweiten Luftkanalbereich (4332) und der zweiten Zelle (432) befindet.

9. Energiespeichermodul (43) nach Anspruch 1, wobei mindestens zwei erste Zellen (431) in einer dritten Richtung (A3) beabstandet sind, mindestens zwei zweite Zellen (432) in der dritten Richtung (A3) beabstandet sind und in der dritten Richtung (A3) der erste Luftkanalbereich (4331) zwischen benachbarten ersten Zellen (431) angeordnet ist, der zweite Luftkanalbereich (4332) zwischen benachbarten zweiten Zellen (432) angeordnet ist und die dritte Richtung (A3) zu einer Ausdehnungsrichtung des Luftkanals (4300) senkrecht ist.

10. Energiespeichermodul (43) nach Anspruch 9, wobei das Lufteinlassende (4301) mit einer Lufteinlasstafel (451) versehen ist, die Lufteinlasstafel (451) mit einem ersten Lochbereich (4511), einem zweiten Lochbereich (4512) und einem dritten Lochbereich (4513) versehen ist, die in der dritten Richtung (A3) sequenziell angeordnet sind, der erste Lochbereich (4511), der zweite Lochbereich (4512) und der dritte Lochbereich (4513) mit Lufteinlasslöchern (4516) versehen und in Kommunikation mit dem mechanischen Luftkanalteil (433, 4333, 4334, 4335) sind und eine Anzahl von Lufteinlasslöchern (4516) im zweiten Lochbereich (4512) größer als eine Anzahl von Lufteinlasslöchern (4516) im ersten Lochbereich (4511) und größer als eine Anzahl von Lufteinlasslöchern (4516) im dritten Lochbereich (4513) ist oder eine Größe des Lufteinlasslochs (4516) im zweiten Lochbereich (4512) größer als eine Größe des Lufteinlasslochs (4516) im ersten Lochbereich (4511) und größer als eine Größe des Lufteinlasslochs (4516) im dritten Lochbereich (4513) ist.

11. Energiespeichermodul (43) nach Anspruch 10, wobei das Energiespeichermodul (43) eine Seitentafel (437, 438) und eine Sammelschiene (454) umfasst, die Seitentafel (437, 438) und die erste Zelle (431) in einer zweiten Richtung (A2) beabstandet sind, die zweite Richtung (A2) zu einer Ausdehnungsrichtung des Luftkanals (4300) senkrecht ist, die Sammelschiene (454) an einer Seite befestigt ist, die von der ersten Zelle (431) stammt und die der Seitentafel (437, 438) zugewandt ist, eine Lücke (459) zwischen der Sammelschiene (454) und der Seitentafel (437, 438) vorhanden ist, die Lufteinlasstafel (451) mit einem Seitenlochbereich (4515) versehen ist, der Seitenlochbereich (4515) und der erste Lochbereich (4511) mit einem Öffnungswinkel angeordnet sind und ein Lufteinlassloch (4516) des Seitenlochbereichs (4515) mit der Lücke (459) in Kommunikation ist.

12. Energiespeichermodul (43) nach Anspruch 1, wobei das Energiespeichermodul (43) einen Einzelplattenkasten (457) und eine Einzelplatte (456), die sich im Einzelplattenkasten (457) befindet, umfasst, das Luftauslassende (4302) mit einer Luftsteuerkomponente (453) versehen ist, der mechanische Luftkanalteil (433, 4333, 4334, 4335) in Kommunikation mit der Luftsteuerkomponente (453) ist, der Einzelplattenkasten (457) mit einer Luftauslassseite (4571) versehen ist, die Luftauslassseite (4571) mit der Luftsteuerkomponente (453) in Kommunikation ist und die Luftsteuerkomponente (453) konfiguriert ist, für die Einzelplatte (456) Wärme abzuleiten.

13. Energiespeichervorrichtung (40), die ein Gehäuse (41), eine Temperatursteuerkomponente (42) und das Energiespeichermodul (43) nach einem der Ansprüche 1 bis 12 umfasst, wobei sowohl das Energiespeichermodul (43) als auch die Temperatursteuerkomponente (42) sich im Gehäuse (41) befinden und die Temperatursteuerkomponente (42) konfiguriert ist, für das Energiespeichermodul (43) Wärme abzuleiten.

14. Stromerzeugungssystem (10), das einen Transformator (80) und die Energiespeichervorrichtung (40) nach Anspruch 13 umfasst, wobei die Energiespeichervorrichtung (40) mit dem Transformator (80) verbunden ist.

## Revendications

1. Module de stockage d'énergie (43), comprenant une première cellule (431), une deuxième cellule (432), et une partie mécanique de canal d'air (433, 4333, 4334, 4335), un canal d'air (4300) étant agencé à l'intérieur de la partie mécanique de canal d'air (433, 4333, 4334, 4335), la partie mécanique de canal d'air (433, 4333, 4334, 4335) comprenant une extrémité d'entrée d'air (4301) et une extrémité de sortie d'air (4302) situées aux deux extrémités du canal d'air (4300), la première cellule (431) et la deuxième cellule (432) étant agencées à l'extérieur de la partie mécanique de canal d'air (433, 4333, 4334, 4335) et étant agencées successivement entre l'extrémité d'entrée d'air (4301) et l'extrémité de sortie d'air (4302), la première cellule (431) étant située entre la deuxième cellule (432) et l'extrémité d'entrée d'air (4301), la partie mécanique de canal d'air (433, 4333, 4334, 4335) comprenant une première région de canal d'air (4331) et une deuxième région de canal d'air (4332), l'extrémité d'entrée d'air (4301) étant située dans la première région de canal d'air (4331) et l'extrémité de sortie d'air (4302) étant située dans la deuxième région de canal d'air (4332), la première région de canal d'air (4331) étant agencée en correspondance avec la première cellule (431), la deuxième région de canal d'air (4332) étant agencée en correspondance avec la deuxième cellule (432), et une surface de dissipation thermique par unité de volume de la deuxième région de canal d'air (4332) étant supérieure à une surface de dissipation thermique par unité de volume de la première région de canal d'air, de manière à réduire une différence de température entre la deuxième cellule (432) et la première cellule (431), la partie mécanique de canal d'air (433, 4333, 4334, 4335) comprenant une partie de dissipation thermique (434), la partie de dissipation thermique (434) étant fixée à une paroi intérieure de la deuxième région de canal d'air (4332), et la partie de dissipation thermique (434) étant configurée pour augmenter la surface de dissipation thermique par unité de volume de la deuxième région de canal d'air (4332).

2. Module de stockage d'énergie (43) selon la revendication 1, dans lequel une direction d'extension du canal d'air (4300) constitue une première direction (A1), une deuxième direction (A2) est perpendiculaire à la première direction (A1) et, dans la deuxième direction (A2), la deuxième région de canal d'air (4332) comprend une portion intermédiaire (4332-3) et des bords (4332-1, 4332-2) situés de part et d'autre de la portion intermédiaire (4332-3), une longueur de la partie de dissipation thermique (434) dans la portion intermédiaire (4332-3) est supérieure à une longueur de la partie de dissipation thermique (434) sur le bord (4332-1, 4332-2), et la longueur représente une taille d'extension de la partie de dissipation thermique (434) dans la première direction (A1).

3. Module de stockage d'énergie (43) selon la revendication 1, dans lequel une direction d'extension du canal d'air (4300) constitue une première direction (A1), la deuxième région de canal d'air (4332) comprend une première sous-région (4332-6), une deuxième sous-région (4332-7), et une troisième sous-région (4332-8) réparties successivement dans la première direction (A1), une extrémité de la troisième sous-région (4332-8) éloignée de la deuxième sous-région (4332-7) constitue l'extrémité de sortie d'air (4302), une surface de dissipation thermique par unité de volume de la troisième sous-région (4332-8) est supérieure à une surface de dissipation thermique par unité de volume de la deuxième sous-région (4332-7), et la surface de dissipation thermique par unité de volume de la deuxième sous-région (4332-7) est supérieure à une surface de dissipation thermique par unité de volume de la première sous-région (4332-6).

4. Module de stockage d'énergie (43) selon l'une quelconque des revendications 1 à 3, dans lequel un nombre de premières cellules (431) agencées est supérieur à un nombre de deuxièmes cellules (432) agencées dans la direction d'extension du canal d'air (4300).

5. Module de stockage d'énergie (43) selon la revendication 1, dans lequel la partie de dissipation thermique (434) comprend une première plaque (4341), une deuxième plaque (4342), une troisième plaque (4343), et une quatrième plaque (4344) reliées successivement, la deuxième plaque (4342) et la quatrième plaque (4344) sont espacées dans une deuxième direction (A2), la première plaque (4341) et la troisième plaque (4343) sont agencées en quinconce dans la deuxième direction (A2), et la deuxième direction (A2) est perpendiculaire à une direction d'extension du canal d'air (4300).

6. Module de stockage d'énergie (43) selon la revendication 1, dans lequel la partie de dissipation thermique (434) comprend une ailette dissipatrice de chaleur (4345), et l'ailette dissipatrice de chaleur (4345) est fixée à la paroi intérieure de la deuxième région de canal d'air (4332).

7. Module de stockage d'énergie (43) selon la revendication 1, dans lequel la partie de dissipation thermique (434) comprend une plaque pliée (4346), et la plaque pliée (4346) est fixée à la paroi intérieure du deuxième canal d'air (4300).

8. Module de stockage d'énergie (43) selon l'une quelconque des revendications 1 à 7, le module de stockage d'énergie (43) comprenant une partie conductrice de chaleur (435), et la partie conductrice de chaleur (435) est située entre la deuxième région de canal d'air (4332) et la deuxième cellule (432).

9. Module de stockage d'énergie (43) selon la revendication 1, dans lequel au moins deux premières cellules (431) sont espacées dans une troisième direction (A3), au moins deux deuxièmes cellules (432) sont espacées dans la troisième direction (A3) et, dans la troisième direction (A3), la première région de canal d'air (4331) est agencée entre des premières cellules (431) adjacentes, la deuxième région de canal d'air (4332) est agencée entre des deuxièmes cellules (432) adjacentes, et la troisième direction (A3) est perpendiculaire à une direction d'extension du canal d'air (4300).

10. Module de stockage d'énergie (43) selon la revendication 9, dans lequel l'extrémité d'entrée d'air (4301) est pourvue d'un panneau d'entrée d'air (451), le panneau d'entrée d'air (451) est pourvu d'une première région de trous (4511), d'une deuxième région de trous (4512), et d'une troisième région de trous (4513) agencées successivement dans la troisième direction (A3), la première région de trous (4511), la deuxième région de trous (4512), et la troisième région de trous (4513) sont toutes pourvues de trous d'entrée d'air (4516) et en communication avec la partie mécanique de canal d'air (433, 4333, 4334, 4335), et un nombre de trous d'entrée d'air (4516) dans la deuxième région de trous (4512) est supérieur à un nombre de trous d'entrée d'air (4516) dans la première région de trous (4511) et supérieur à un nombre de trous d'entrée d'air (4516) dans la troisième région de trous (4513), ou bien une taille du trou d'entrée d'air (4516) dans la deuxième région de trous (4512) est supérieure à une taille du trou d'entrée d'air (4516) dans la première région de trous (4511) et supérieure à une taille du trou d'entrée d'air (4516) dans la troisième région de trous (4513).

11. Module de stockage d'énergie (43) selon la revendication 10, le module de stockage d'énergie (43) comprenant un panneau latéral (437, 438) et un barre omnibus (454), le panneau latéral (437, 438) et la première cellule (431) sont espacés dans une deuxième direction (A2), la deuxième direction (A2) est perpendiculaire à une direction d'extension du canal d'air (4300), la barre omnibus (454) est fixée à un côté de la première cellule (431) faisant face au panneau latéral (437, 438), un espace (459) est présent entre la barre omnibus (454) et le panneau latéral (437, 438), le panneau d'entrée d'air (451) est pourvu d'une région de trous latérale (4515), la région de trous latérale (4515) et la première région de trous (4511) sont agencées en formant un angle inclus, et un trou d'entrée d'air (4516) de la région de trous latérale (4515) est en communication avec l'espace (459).

12. Module de stockage d'énergie (43) selon la revendication 1, le module de stockage d'énergie (43) comprenant un boîtier à plaque unique (457) et une plaque unique (456) située dans le boîtier à plaque unique (457), l'extrémité de sortie d'air (4302) est pourvue d'un composant de régulation d'air (453), la partie mécanique de canal d'air (433, 4333, 4334, 4335) est en communication avec le composant de régulation d'air (453), le boîtier à plaque unique (457) est pourvu d'un côté de sortie d'air (4571), le côté de sortie d'air (4571) est en communication avec le composant de régulation d'air (453), et le composant de régulation d'air (453) est configuré pour dissiper la chaleur pour la plaque unique (456).

13. Appareil de stockage d'énergie (40), comprenant une enveloppe (41), un composant de régulation de température (42), et le module de stockage d'énergie (43) selon l'une quelconque des revendications 1 à 12, le module de stockage d'énergie (43) et le composant de régulation de température (42) étant tous deux situés dans l'enveloppe (41), et le composant de régulation de température (42) étant configuré pour dissiper la chaleur pour le module de stockage d'énergie (43).

14. Système de production d'énergie électrique (10), comprenant un transformateur (80) et l'appareil de stockage d'énergie (40) selon la revendication 13, l'appareil de stockage d'énergie (40) étant relié au transformateur (80).
